(19) **Europäisches Patentamt**

**European Patent Office**

**Office européen des brevets**

(11) **EP 0 659 002 B1**

(12) **EUROPÄISCHE PATENTSCHRIFT**

(45) Veröffentlichungstag und Bekanntmachung des Hinweises auf die Patenterteilung:
**10.12.2003 Patentblatt 2003/50**

(51) Int Cl.⁷: **H04L 29/14**, H04L 1/00, H04B 1/10, H03M 13/00

(21) Anmeldenummer: **94202953.9**

(22) Anmeldetag: **12.10.1994**

(54) **Verfahren und Schaltungsanordnung zur Übertragung von Sprachsignalen**

Method and circuit for the transmission of voice signals

Méthode et circuit pour la transmission des signaux vocaux

(84) Benannte Vertragsstaaten:
**DE FR GB IT**

(30) Priorität: **16.10.1993 DE 4335305**

(43) Veröffentlichungstag der Anmeldung:
**21.06.1995 Patentblatt 1995/25**

(73) Patentinhaber:
- **Philips Intellectual Property & Standards GmbH 20099 Hamburg (DE)**
  Benannte Vertragsstaaten:
  **DE**
- **Koninklijke Philips Electronics N.V. 5621 BA Eindhoven (NL)**
  Benannte Vertragsstaaten:
  **FR GB IT**

(72) Erfinder:
- **Lorenz, Dietmar, c/o Philips Patentverw. Gmbh D-20097 Hamburg (DE)**
- **Hellwig, Karl, c/o Philips Patentverw. Gmbh D-20097 Hamburg (DE)**

(74) Vertreter: **Volmer, Georg, Dipl.-Ing. et al Philips Intellectual Property & Standards GmbH, Postfach 50 04 42 52088 Aachen (DE)**

(56) Entgegenhaltungen:
DE-A- 2 826 364    DE-A- 2 948 435
DE-A- 3 150 365    DE-A- 3 535 178
DE-A- 3 608 917    DE-A- 4 111 131
DE-A- 4 135 005    DE-A- 4 208 995
DE-A- 4 219 400    DE-C- 4 135 070
US-A- 4 380 069    US-A- 4 719 642
US-A- 5 243 428

**Beschreibung**

Die Erfindung betrifft ein System mit einer ersten Station und wenigstens einer zweiten Station zur Übertragung von Sprachsignalen zwischen einer der zweiten Stationen und der ersten Station, wobei jede Station einen Sendeteil zum Umsetzen der Sprachsignale eines Zeitabschnitts vorgegebener Dauer in mehrere aus Bits bestehende Codewortgruppen mit unterschiedlicher Bedeutung und zum Umsetzen der Bits in Kanalbits eines Kanalcodes und zum Aussenden der Kanalbits als Bitblock sowie einen Empfänger enthält mit einem Empfangsteil zum Empfangen und Demodulieren von ausgesandten Bitblöcken zur Erzeugung von Kanalbits und einem Kanaldecoder zum Erzeugen von Codewortgruppen unterschiedlicher Bedeutung aus den Kanalbits an einem Kanalausgang und zum Erzeugen von Fehlermeldesignalen an wenigstens einem Fehlerausgang,
wobei wenigstens zweite Stationen eine mit dem Kanalausgang gekoppelte Fehlerverschleierungsschaltung mit einem Speicher für Codewortgruppen eines vorhergehenden Bitblocks, um abhängig von Fehlermeldesignalen modifizierte Codewortgruppen zu erzeugen, und einen Sprachdecoder zum Erzeugen von Sprachsignalen aus den modifizierten Codewortgruppen enthält, sowie einen Empfänger zum Empfang derartig aufgebauter Bitblöcke und ein Verfahren zur Übertragung von Sprachsignalen.

Ein derartiges System, bei dem die erste Station eine ortsfeste Station und die zweiten Stationen bewegliche Stationen sind, entspricht dem digitalen europäischen Mobilfunkfernsprechsystem nach dem GSM-Full-Rate-Standard, in Deutschland D1-Netz bzw. D2-Netz, und ist beispielsweise in der Zeitschrift "Frequenz" 42 (1988), Heft 2/3, Seiten 85 bis 93, beschrieben. Um Sprachsignale mit ausreichender Qualitat, wie es beispielsweise eine logarithmische PCM-Codierung mit 8 Bit pro Sample bei 8 kHz Abtastfrequenz der Fall ist, zu übertragen, ist eine Bitrate von 64 kBit/s erforderlich, die im leitungsgebundenen Fernsprechsystem zur Verfügung steht. Für die Übertragung im digitalen Funkfernsprechnetz ist die effektive Bitrate für Sprachsignale aus Gründen der Frequenzökonomie auf maximal 13 kBit/s beschränkt, so daß für die Übertragung von Sprachsignalen mit ausreichender Qualität Verfahren der Quellencodierung angewendet werden müssen. Dafür wird das Sprachsignal bekanntlich, wie auch aus der vorgenannten Literaturstelle hervorgeht, auf komplexe Weise verarbeitet, um für jeweils einen Zeitabschnitt von 20 ms des Sprachsignals mehrere Codewörter zu erhalten, die als zusammenhängender Bitblock ausgesendet werden.

In der DE 41 35 070 wird ein System angegeben, bei dem zwischen einer ersten Station und wenigstens einer zweiten Station Tonsignale übertragen werden. Diese Übertragung erfolgt über störbehaftete Kanäle und die Tonsignale enthalten eine Folge von Informationsblöcken aus Informationseinheiten unterschiedlichen Inhalts. Das enkodierte Tonsignal wird vor einer Übertragung und einer Speicherung einer entsprechend dem gewünschten Fehlerschutz bemessenen Kanalcodierung unterzogen, wobei im Falle einer Fehlererkennung eine Fehlerkorrektur und bei nicht korrigierbaren Fehlern eine Fehlerverschleierung erfolgt. Es wird ein variabler Bitfehlerschutz angegeben. Informationseinheiten bezüglich der encodierten Abtastwerte von tieferfrequenten Tonsignalen erhalten einen höheren Bitfehlerschutz als Informationseinheiten von höherfrequenten Tonsignalanteilen einen und der zu wählende Fehlerschutz wird in Abhängigkeit von der nach subjektiven Kriterien zulässigen Dauer und Häufigkeit einer angewendeten Fehlerverschleierung bestimmt. Es wird angegeben, daß die Bitzuweisungsinformation und die Skalenfaktor- Selektierungsinformation einen hohen Fehlerschutz benötigen. Diese beiden Informationseinheiten werden neben den anderen Informationseinheiten auch übertragen. Um Fehler in den Informationseinheiten besser erkennen zu können, ist zwischen die Einheiten 13 und 14 ein eine zusätzliche Informationseinheit 40 mit zusätzlichem Fehlerschutz 50 eingefügt worden, die auch mit übertragen wurde. Es wird angegeben, daß anhand des mitübertragenen Fehlerschutzes eine besserer Fehlererkennung ermöglicht wird. Zur Möglichkeit der Fehlerverschleierung wird angegeben, däß gestörte Informationseinheiten durch Informationseinheiten im Nachbarkanal oder im selben Kanal ersetzt werden, wobei diese dann im vorhergehenden Informationsblock in der selben Teilgruppe vorliegen.

In der DE OS 28 26364 wird ein Verfahren zur Übertragung codierter Tonsignale im Pulsrahmen des Fernsprechsystem PCM 30 beschrieben, bei dem zur Fehlersicherung Paritätsbits mitübertragen werden. Ein Schutz gegen auf dem Übertragungsweg entstandene Bitfehler wird durch eine bekannte Fehlerüberdeckungstechnik gewährleistet. Nach dem Erkennen einer Verletzung einer Parität auf der Empfangsseite, wird das mit dem Bitfehler behaftete Codewort unterdrückt und durch einen Schätzwert ersetzt. Es wird beschrieben, einen fehlerhaften Abtastwert durch denjenigen Abtastwert zu ersetzen, der im vorhergehenden Intervall auftrat. Außerdem wird angegeben, einen Schätzwert durch Mittelwertbildung aus den Codeworten der vorhergehenden und nachfolgenden Intervalle zu erzeugen.

Die Codewörter eines Bitblocks haben unterschiedliche Bedeutung, und Störungen in diesen Codewörtern wirken sich bei den auszugebenden Sprachsignalen unterschiedlich aus, und außerdem ist es auch wesentlich, welche Bitstelle eines Codewortes gegebenenfalls gestört wird.

Aus diesem Grunde sind aus einzelnen Codewörtern die Bits mit größter Auswirkung auf das auszugebende Sprachsignal zusammengefaßt und mit einem Prüfwort versehen, um auf der Empfangsseite leichter ein Qualitätsmerkmal gewinnen und besser erkennen zu können, ob der Bitblock nach der Kanaldecodierung immer noch derart gestört ist, daß bei auszugebenden Sprachdaten unangenehme Geräusche erzeugt werden. Zusätzlich werden diese mit dem Prüfwort gesicherten Bits der Codewörter mit weiteren Bits, die geringere Auswirkungen haben, einer Kanalcodierung unterworfen, die eine gewisse Fehlerkorrektur ermöglicht. Bits an Bitstellen von Codewörtern mit geringster Bedeutung, bei denen Fehler zwar keine sehr unangenehmen Störungen im abzugebenden Sprachsignal erzeugen, die für eine gute Sprachqualität jedoch von Bedeutung sind, werden schließlich nicht weiter codiert und ungesichert übertragen. Bei dem bekannten mobilen Funkfernsprechsystem werden Fehlerverschleierungsmaßnahmen bei den empfangenen Bitblöcken bzw. den daraus gewonnenen Codewörtern nur dann vorgenommen, wenn mittels des Prüfworts ein Fehler festgestellt wird, weil nur dann von einer stärkeren Störung im Sprachsignal ausgegangen wird. Bei einer solchen Störung werden dann die Codewörter des vorhergehenden Bitblocks wiederholt. Dies bewirkt zwar eine gewisse Verfälschung des Sprachsignals, die jedoch subjektiv weniger unangenehm ist als ein aus Codewörtern, bei denen die wichtigsten Bitstellen gestört sind, gebildetes Sprachsignal.

Es ist nun festgestellt worden, daß die Sicherung der wichtigsten Bits der Codewörter durch das verwendete Prüfwort nicht immer ausreichend ist, denn insbesondere bei einem stärkeren Ausmaß der Störungen können diese wichtigsten Bits der Codewörter gestört sein, ohne daß mittels des Prüfworts ein Fehler festgestellt wird, da sich die durch die Störungen hervorgerufenen Fehler insgesamt aufheben. Andererseits können größere Störungen in den übrigen Bitstellen der Codewörter, die also weniger bzw. gar nicht fehlergesichert sind und bei denen Störungen bzw. Fehler empfangsseitig nicht erkannt werden können, sich doch in stärkeren unangenehmen Geräuschen im ausgegebenen Sprachsignal bemerkbar machen.

Aufgabe der Erfindung ist es daher, ein System der eingangs genannten Art anzugeben, in dem auch geringere Störungen im empfangenen Bitblock erkannt werden können und insgesamt verschiedene Ausmaße von Störungen so behandelt werden, daß jeweils nur möglichst geringe Auswirkungen im ausgegebenen Sprachsignal entstehen.

Diese Aufgabe wird erfindungsgemäß bei der genannten Schaltungsanordnung durch die kennzeichnenden Merkmale des Anspruch 1 gelöst.

Die Erfindung geht aus von der Erkenntnis, daß bei der Kanal-Decodierung wesentlich mehr Aussagen über Störungen im empfangenen Bitblock erhalten werden können, als bei dem bekannten System nur durch das Prüfwort möglich ist. Da andererseits die einzelnen Codewörter eines Bitblocks unterschiedliche Bedeutung haben und sich somit auch unterschiedlich auf das auszugebende Sprachsignal auswirken, werden diese verschiedenen Codewörter erfindungsgemäß bei unterschiedlichen Störungen auch unterschiedlich modifiziert. Dies ergibt eine wesentliche Verbesserung der Qualität der ausgegebenen Sprachsignale im Falle von Störungen im empfangenen Bitblock.

Bei dem eingangs erwähnten Funkfernsprechsystem, in dem in jeder Station der Sendeteil eingerichtet ist, um aus den Sprachsignalen jedes Zeitabschnitts eine erste, eine zweite, eine dritte und eine vierte Codewortgruppe zu erzeugen, die jede mehrere Bits umfassen, und aus den Bits an vorgegebenen Bitstellen der Codewörter zusammen ein Prüfwort mit wenigstens einem Bit zu bilden und mit den Kanalbits des Bitblocks auszusenden, ist es nach einer Ausgestaltung der Erfindung zweckmäßig, daß der Kanal-Decoder eingerichtet ist, um an einem ersten Fehlerausgang ein Prüfwortfehlersignal und außerdem an einem zweiten Fehlerausgang einen Fehlerwert abzugeben, und daß die Fehlerverschleierungsschaltung einen ersten Schwellwertvergleicher zum Vergleichen des Fehlerwerts mit mehreren Fehler-Schwellwerten, eine wenigstens mit dem ersten Fehlerausgang des Kanaldecoders gekoppelte Störindikatorschaltung, um abhängig wenigstens vom Prüfwortfehlersignal am ersten Fehlerausgang ein Störindikatorsignal zu erzeugen, eine Klassifizierschaltung, die mit dem ersten Schwellwertvergleicher gekoppelt ist, um abhängig von dem überschrittenen Fehler-Schwellwert und dem Störindikatorsignal eines von einer Anzahl unterschiedlicher Fehlerklassensignale zu erzeugen, und eine von den Fehlerklassensignalen angesteuerte Codewortsteuerung enthält, um abhängig von zugeführten Fehlerklassensignalen wenigstens einige der vom Kanaldecoder abgegebenen Codewortgruppen zu modifizieren, insbesondere durch ein aus den Codewörtern des Speichers abgeleitete Codewortgruppe zu ersetzen. Durch die Fehler-Schwellwerte können auf einfache Weise mehrere Fehlerklassen gebildet werden, und schon bei sehr wenigen Fehlerklassen ist eine sehr individuelle Modifizierung der Codewortgruppen möglich. Da sich einige Codewortgruppen auf das Sprachsignal im gesamten Zeitabschnitt besonders stark auswirken, ist schon bei geringen Fehlerraten eine Modifizierung dieser Codewortgruppen günstig. Bei größeren Fehlerraten müssen selbstverständlich auch die anderen Codewortgruppen modifiziert werden.

Bei dem bekannten Funkfernsprechsystem werden Fehlerverschleierungsmaßnahmen bei den von der festen Station ausgesandten Bitblöcken vollständig in der beweglichen Station durchgeführt. Im umgekehrten Falle werden Fehlerverschleierungsmaßnahmen an den von der beweglichen Station ausgesandten Bitblöcken nicht in der festen Station durchgeführt, sondern die feste Station führt die Kanaldecocierung durch und überträgt die empfangenen Codewörter zusammen mit einem Signal, das einen mittels des Prüfworts erkannten Fehler angibt, an eine zentrale Station, wo die Fehlerverschleierungsmaßnahmen durchgeführt und die Sprachsignale wieder hergestellt und in das drahtgebundene Fernsprechnetz eingespeist werden. Diese Durchführung von Fehlerverschleierungsmaßnahmen erfolgt vor allem deshalb, weil die Fehlerverschleierungsmaßnahmen als Einheit mit der Einrichtung zur Ausgabe von Sprachdaten aus den empfangenen Codewörtern behandelt wird und die Verbindung zwischen der festen Station und der zentralen Station nur eine geringe Bandbreite hat. Wegen dieser geringen Bandbreite könnten nur wenige Informationen über die Zuverlässigkeit der empfangenen Bitblöcke, die bei der Kanal-Decodierung grundsätzlich gebildet werden können, übertragen werden, so daß nur einfache Fehlerverschleierungsmaßnahmen, nämlich eine Wiederholung der Codewörter des vorhergehenden Bitblocks, bei einem mittels des Prüfworts festgestellten Fehler vorgenommen werden können. Andererseits ist das Übertragungsformat zwischen der festen Station und der zentralen Station festgelegt, indem außer bestimmter Steuerinformation nur die Codewörter und ein Bit, das die Erkennung eines Fehlers mittels des Prüfworts angibt, übertragen werden. Um dennoch umfangreichere Fehlerverschleierungsmaßnahmen durchführen zu können, ohne dieses Übertragungsformat zu verändern, ist es bei einem erfindungsgemäßen System, in dem die erste Station eine ortsfeste Station und die zweiten Stationen bewegliche Stationen sind, nach einer weiteren Ausgestaltung der Erfindung zweckmäßig, daß auch in der ortsfesten Station der Kanaldecoder zur Erzeugung wenigstens der Fehlersignale eingerichtet ist und die Fehlerverschleierungsschaltung zum Modifizieren der Codewörter des Kanaldecoders abhängig von den Fehlersignalen in der festen Station vorgesehen ist. Die Durchführung der Fehlerverschleierungsmaßnahmen wird somit vollständig von der Wiederherstellung der Sprachsignale getrennt, und dadurch können umfangreiche Fehlerverschleierungsmaßnahmen durchgeführt werden, da innerhalb der festen Station nahezu beliebig viele Informationen zwischen dem Kanaldecoder und einer Fehlerverschleierungsanordnung ausgetauscht werden können. Es werden dann stets Codewörter abgegeben, die in der Fehlerverschleierungsanordnung bereits verarbeitet wurden, und das Bit, das die Erkennung des Fehlers mittels des Prüfworts angeben soll, erhält ständig einen Signalwert entsprechend fehlerfreier Prüfwörter. Dadurch sind in der zentralen Station keine Änderungen vorzunehmen, sondern diese führt lediglich keine Fehlerverschleierungsmaßnahmen mehr durch, da sie nur als fehlerfrei gekennzeichnete Codewörter erhält. Auf diese Weise ist die Durchführung der umfangreichen erfindungsgemäßen Fehlerverschleierungsmaßnahmen kompatibel mit dem bekannten Funkfernsprechsystem.

Die Erfindung betrifft weiter ein System mit wenigstens einer ortsfesten Station und wenigstens einer beweglichen Station zur Übertragung von Sprachsignalen zwischen der beweglichen Station und der ortsfesten Station, wobei jede Station einen Sendeteil zum Umsetzen der Sprachsignale eines Zeitabschnitts vorgegebener Dauer in mehrere aus Bits bestehende Codewortgruppen mit unterschiedlicher Bedeutung und zum Umsetzen der Bits in Kanalbits eines Kanalcodes und zum Aussenden der Kanalbits als Bitblock sowie eine Schaltungsanordnung mit einem oben beschriebenen Empfänger. Es wird ausgenutzt, daß von dem Kanaldecoder eine genauere Information über das Ausmaß von Störungen erhalten werden kann, so daß verschiedene Maßnahmen zur Fehlerverschleierung gezielt eingesetzt werden können. Zum Modifizieren der Codewortgruppen ist es gemäß einem Aspekt der Erfindung auch nicht notwendig, alle Codewortgruppen des vorhergehenden Bitblocks zu speichern, da einige Bitblöcke bei bestimmten Fehlern bzw. Störungen auch durch feste Werte ersetzt werden können, wie später in den Ausführungsbeispielen näher erläutert wird.

Weitere Ausbildungen des erfindungsgemäßen Empfängers sind in weiteren Unteransprüchen angegeben.

Die Erfindung betrifft weiter ein Verfahren zur Übertragung von Sprachsignalen nach Anspruch 10.

Bei diesem Verfahren sollen für unterschiedliche Ausmaße von Störungen im empfangenen Bitblock gut angepaßte Maßnahmen zur Fehlerverschleierung anwendbar sein, damit für jeden Störungsfall nur möglichst geringe Auswirkungen im ausgegebenen Sprachsignal entstehen. Dafür ist das erfindungsgemäße Verfahren dadurch gekennzeichnet, daß bei der Kanal-Decodierung als Qualitätsmerkmal Informationen über die Zuverlässigkeit der empfangenen Bitblöcke, insbesondere über deren Fehlereigenschaften erzeugt werden und daß abhängig von diesen Informationen als Fehlerverschleierungsmaßnahmen unterschiedliche der bei der Kanal-Decodierung gewonnenen Codewörter in unterschiedlicher Weise modifiziert werden.

Das erfindungsgemäße Verfahren basiert darauf, daß es möglich ist, bei der Kanaldecodierung das Ausmaß der Störungen genauer festzustellen und dadurch gezielt unterschiedliche Maßnahmen zur Fehlerverschleierung durchzuführen.

Insbesondere bei dem eingangs erwähnten bekannten Funkfernsprechsystem, wobei im empfangenen Bitblock eine erste Codewortgruppe Filterkoeffizienten, eine zweite Codewortgruppe Amplitudenwerte, eine dritte Codewortgruppe Langzeit-Koeffizienten und eine vierte Codewortgruppe einzelne codierte Restsignale des Sprachsignals für die Rekonstruktion von auszugebenden Sprachsignalen angeben und vorgegebene Bits von Codewortgruppen sendeseitig zusammengefaßt mit einem Prüfwort versehen sind, das empfangsseitig zurückgewonnen wird, ist es zweckmäßig, daß bei der Kanal-Decodierung ein Fehlerwert entsprechend einer geschätzten Bitfehlerhäufigkeit gebildet und mit mehreren Fehler-Schwellwerten verglichen wird und daß abhängig vom überschrittenen Fehler-Schwellwert und vom Wert eines Störindikators, der wenigstens von einem mittels des Prüfworts erkannten Fehler abhängt, eine von einer vorgegebenen Anzahl Fehlerklassen gebildet wird und für verschiedene Fehlerklassen wenigstens die ersten beiden Codewortgruppen modifiziert werden. Durch die Bildung von Fehlerklassen können Maßnahmen zum Modifizieren der Codewortgruppen einfach ausgewählt werden.

Bei dem bekannten Funkfernsprechsystem hängt der Störindikator nur von der Erkennung eines Fehlers mittels des Prüfworts oder von der Erkennung eines Bitblocks als Steuerwort ohne Sprachinformation ab. Für besser angepaßte Fehlerverschleierungsmaßnahmen sollten jedoch noch weitere Fehlereigenschaften berücksichtigt werden. Eine weitere Ausgestaltung der Erfindung, bei der außerdem mit nur wenigen Fehlerklassen wirksame Fehlerverschleierungsmaßen möglich sind, ist daher dadurch gekennzeichnet, daß der Störindikator ein binärer Wert ist und gebildet wird, wenn wenigstens eine der folgenden Bedingungen erfüllt ist:

a) mittels des Prüfworts wird ein Fehler erkannt,

b) ein bei der Kanal-Decodierung gebildeter Metrikwert überschreitet einen vorgegebenen Metrik-Schwellwert,

c) der Fehlerwert überschreitet einen vorgegebenen ersten Fehler-Schwellwert,

daß eine erste Fehlerklasse gebildet wird, wenn bei fehlendem Störindikator der Fehlerwert zwischen einem zweiten und einem dritten Fehler-Schwellwert liegt, wobei für diese erste Fehlerklasse in der ersten Codewortgruppe die Angaben für wenigstens die ersten beiden Filterkoeffizienten mit Filterschwellwerten verglichen werden und bei Überschreiten dieser Filterschwellwerte durch wenigstens eine Angabe die modifizierte erste Codewortgruppe durch die erste Codewortgruppe des vorhergehenden gespeicherten Bitblocks gebildet wird und in der zweiten Codewortgruppe jeder Amplitudenwert mit einem aus den Amplitudenwerten des vorhergehenden Bitblocks abgeleiteten Amplitudenmittelwert verglichen wird und bei Abweichung von diesem Amplitudenmittelwert um ein vorgegebenes Maß in der modifizierten Codewortgruppe durch diesen Amplitudenmittelwert ersetzt wird, und die modifizierte dritte und vierte Codewortgruppe gleich der entsprechenden empfangenen Codewortgruppe ist,

daß eine zweite Fehlerklasse gebildet wird, wenn bei vorhandenem Störindikator der Fehlerwert einen vierten Fehler-Schwellwert nicht überschreitet oder bei fehlendem Störindikator im vorhergehenden Bitblock der Störindikator vorhanden war und der Fehlerwert im momentanen Bitblock einen fünften Fehler-Schwellwert überschreitet, und für diese zweite Fehlerklasse die modifizierte erste und zweite Codewortgruppe die entsprechende gespeicherte Codewortgruppe des vorhergehenden Bitblocks ist und die modifizierte dritte und vierte Codewortgruppe gleich der entsprechenden empfangenen Codewortgruppe ist, und

daß eine dritte Fehlerklasse gebildet wird, wenn bei vorhandenem Störindikator der Fehlerwert den vierten Fehler-Schwellwert überschreitet, wobei für diese dritte Fehlerklasse die modifizierte erste, zweite und dritte Codewortgruppe die entsprechende gespeicherte Codewortgruppe des vorhergehenden Bitblocks ist und die modifizierte vierte Codewortgruppe aus Zufallswerten besteht. Hierbei wirkt sich besonders günstig aus, daß die modifizierte vierte Codewortgruppe entweder die empfangene Codewortgruppe oder aus Zufallswerten besteht, jedoch dafür niemals die vierte Codewortgruppe des vorhergehenden Bitblocks verwendet werden muß, so daß der Speicher für die Speicherung der Codewörter des vorhergehenden Bitblocks einen geringeren Umfang haben kann, zumal die vierte Codewortgruppe besonders viele Bit umfaßt.

Bei dem bekannten Funkfernsprechsystem werden neben den Bitblöcken mit Codewörtern in einem festen Raster auch Bitblöcke mit Steuerinformationen übertragen, die jedoch wesentlich seltener auftreten als die Bitblöcke mit Codewörtern. Dadurch ist die Möglichkeit, umfangreiche Steuerinformation zu übertragen, begrenzt bzw. erfordert eine Vielzahl von aufeinanderfolgenden Bitblöcken und somit relativ viel Zeit. Wenn daher momentan eine große Menge Steuerinformation übertragen werden muß, wie dies beispielsweise bei dem Wechsel der Verbindung einer bewegten Station zu einer anderen ortsfesten Station der Fall ist, wird bei dem bekannten System ein vollständiger Bitblock, der normalerweise für Sprachinformation reserviert ist, für Steuerinformation benutzt, der somit keine Sprachinformation bzw. keine Codewörter zur Sprachdecodierung enthält. Da dieser Fall einem sehr stark gestört empfangenen Bitblock mit Codewörtern aus Sprachsignalen entspricht, der somit nicht für die Erzeugung auszugebender Sprachsignale verwendet werden kann, ist es nach einer weiteren Ausgestaltung der Erfindung zweckmäßig, daß für einen Bitblock, der als Steuerwort ohne Sprachinformation erkannt wird, die Fehlerverschleierungsmaßnahmen entsprechend der dritten Fehlerklasse durchgeführt werden.

Auf diese Weise wirkt sich ein Bitblock, der nur Steuerinformation enthält, auf die ausgegebenen Sprachsignale kaum aus.

Bei Störungen auf dem Übertragungsweg kann es vorkommen, daß dadurch nicht nur ein Bitblock, sondern zwei oder sogar mehrere aufeinanderfolgende Bitblöcke für die Rekonstruktion der Sprachsignale nicht oder nur bedingt brauchbar sind. In diesem Falle würde insbesondere bei einer längeren Folge gestört empfangener Bitblöcke die unmittelbare Wiederholung aller Codewörter des zuletzt ungestört empfangenen Bitblocks zu einer merkbaren Verfälschung der wiedergegebenen Sprachsignale führen. Bei dem bekannten Funkfernsprechsystem ist es daher üblich, daß beim Feststellen eines Fehlers mittels des Prüfworts in zwei aufeinanderfolgenden Bitblöcken die erste modifizierte Codewortgruppe die gespeicherte erste Codewortgruppe des vorhergehenden Bitblocks ist und die zweite modifizierte Codewortgruppe die um einen festen Betrag reduzierten Amplitudenwerte der gespeicherten zweiten Codewortgruppe enthält und die gespeicherte zweite Codewortgruppe durch die modifzierte zweite Codewortgruppe ersetzt wird. Dadurch werden in der Lautstärke abklingende Sprachsignale erzeugt, was für den Benutzer weniger störend ist. Eine weitere Verbesserung für diesen Fall ist nach einer weiteren Ausgestaltung der Erfindung dadurch gekennzeichnet, daß bei einem Bitblock, für den die zweite Fehlerklasse gebildet wird, die dritte und die vierte modifizierte Codewortgruppe die unveränderte entsprechende Codewortgruppe dieses Bitblocks ist und

daß bei einem Bitblock, für den die dritte Fehlerklasse gebildet wird, die zweite modifizierte Codewortgruppe für alle Amplitudenwerte einen Mittelwert, der aus den Amplitudenwerten der gespeicherten zweiten Codewortgruppe außer dem kleinsten und dem größten Amplitudenwert gebildet ist, enthält und die dritte modifizierte Codewortgruppe die gespeicherte dritte Codewortgruppe des vorhergehenden Bitblocks ist und die vierte modifizierte Codewortgruppe aus Zufallswerten besteht. Dabei wird also auch in diesem Falle unterschieden, welches Ausmaß die Störungen im empfangenen Bitblock haben, so daß bei nicht zu großen Störungen noch Teile der Information im gestörten Bitblock verwendet werden, so daß bei anschließendem Empfang ungestörter bzw. weniger gestörter Bitblöcke ein besserer Übergang im wiedergegebenen Sprachsignal erzeugt wird. Auch in diesem Falle ist die Speicherung der vierten Codewortgruppe aus dem zuletzt ungestört empfangenen Bitblock nicht erforderlich.

In Sprachpausen, in denen also keine zu übertragenden Sprachsignale vorliegen, sondern evtl. Hintergrundgeräusche, sollte Sendeenergie insbesondere in den bewegten Stationen gespart werden. Dafür ist es zweckmäßig, daß der Sender, der die meiste Energie verbraucht, fast vollständig abgeschaltet wird. Dies muß für die empfangende Seite jedoch erkennbar sein. Bei dem bekannten Funkfernsprechsystem ist es daher üblich, daß während Sprachpausen als Sprachsignal ein Hintergrundgeräusch erzeugt wird, das aus den ersten beiden Codewortgruppen eines Bitblocks, der als Hintergrundgeräusch-Bitblock gekennzeichnet ist, gebildet wird. Ein solcher Hintergrundgeräusch-Bitblock wird einmal am Ende eines Sprachsignals übertragen und dann bei längeren Sprachpausen etwa alle halbe Sekunde. Bei der Übertragung eines solchen Hintergrundgeräusch-Bitblocks können jedoch ebenfalls Störungen auftreten, die sich beispielsweise als zu lautes Hintergrundgeräusch oder als unangenehm empfundenes Störgeräusch im wiedergegebenen Sprachsignal auswirken. Bei dem bekannten Funkfernsprechsystem werden daher, wenn in dem empfangenen Hintergrundgeräusch-Bitblock ein Fehler mittels des Prüfworts festgestellt wird, die ersten beiden Codewortgruppen des zuletzt ungestört empfangenen Bitblocks, das ist in einem Hintergrundgeräusch-Bitblock im Anschluß an ein Sprachsignal der letzte Bitblock für dieses Sprachsignal, verwendet. Für die dritte und vierte Codewortgruppe werden ohnehin stets feste Werte bzw. Zufallswerte verwendet. Auch hier ist es jedoch möglich, daß Störungen bei der Übertragung eines Hintergrundgeräusch-Bitblocks sich so auswirken, daß kein Fehler mittels des Prüfworts erkennbar wird. Dann würde etwa eine halbe Sekunde lang bis zur Übertragung des nächsten Hintergrundgeräusch-Bitblocks ein Hintergrundgeräusch wiedergegeben werden, das aus falschen Codewörtern erzeugt wird und als störend empfunden wird. Nach einer weiteren Ausgestaltung der Erfindung ist es daher zweckmäßig, daß für einen zuverlässig erkannten Hintergrundgeräusch-Bitblock, bei dem der Fehlerwert unterhalb eines vorgegebenen sechsten Fehler-Schwellwerts liegt, die modifizierte erste Codewortgruppe die empfangene erste Codewortgruppe ist und in der empfangenen zweiten Codewortgruppe die beiden extremsten Amplitudenwerte weglassen und der Mittelwert der restlichen Amplitudenwerte für alle Amplitudenwerte in der modifizierten zweiten Codewortgruppe verwendet wird und daß für einen zuverlässig erkannten Hintergrundgeräusch-Bitblock, bei dem der Fehlerwert oberhalb des sechsten Fehler-Schwellwertes liegt oder bei dem der Störindikator vorhanden ist, oder für einen nicht zuverlässig erkannten Hintergrundgeräusch-Bitblock als modifizierte erste und zweite Codewortgruppe die einem früheren Bitblock empfangene erste bzw. zweite Codewortgruppe verwendet wird. Durch die Berücksichtigung des Fehlerwertes und dadurch, daß die Amplitudenwerte von Extremwerten befreit und im übrigen gemittelt werden, wird erreicht, daß praktisch unter fast allen Umständen ein nicht störendes Hintergrundgeräusch erzeugt wird.

Bei den vorstehend angegebenen Maßnahmen zur Fehlerverschleierung wird ein Fehlerwert verwendet, der eine geschätzte Bitfehlerhäufigkeit im empfangenen Bitblock angibt. Nach einer Ausgestaltung der Erfindung wird ein solcher Fehlerwert dadurch gebildet, daß die kanaldecodierten Kanalbits erneut kanal-codiert werden und die erneut codierten Bits bitstellenrichtig mit den empfangenen Bits verglichen werden und Bitstellen mit unterschiedlichen Bitwerten zur Erzeugung eines Zählwertes gezählt werden und aus dem Zählwert der Fehlerwert abgeleitet wird. Da insbesondere eine Kanal-Codierung von Bits nur wenig Aufwand erfordert, kann der Fehlerwert auf diese Weise einfach gebildet werden.

Ausführungsbeispiele der Erfindung werden nachstehend anhand der Zeichnung erläutert. Es zeigen:

Fig. 1 schematisch eine Anzahl beweglicher Stationen und eine Anzahl fester Stationen mit einer zentralen Station,
Fig. 2 den grundsätzlichen Aufbau des Empfangsteils einer beweglichen Station,
Fig. 3 den grundsätzlichen Aufbau des Empfangsteils einer festen Station und deren Verbindung mit der zentralen Station,
Fig. 4 den grundsätzlichen Aufbau eines Kanaldecoders mit der Erzeugung weiterer Ausgangssignale, die die Zuverlässigkeit der empfangenen Bitblöcke angeben,
Fig. 5 den Aufbau einer Fehlerverschleierungsschaltung,
Fig. 6a bis 6f Diagramme zur Erläuterung von Fehlerverschleierungsmaßnahmen an Codewörtern bei gestört empfangenen Bitblöcken.

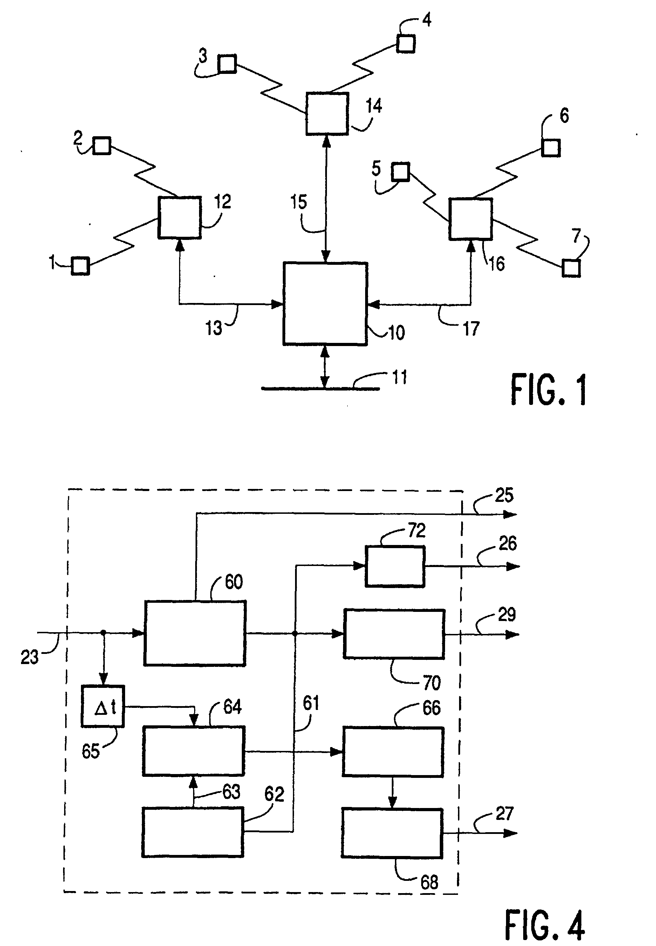

In Fig. 1 ist schematisch der Aufbau und das Zusammenarbeiten der einzelnen Einheiten eines Funkfernsprechsystems nach dem GSM-Standard dargestellt. Eine Anzahl beweglicher Stationen 1 bis 7, beispielsweise Telefone, die in Kraftfahrzeugen angeordnet sind oder als tragbare Telefone mit dem Benutzer mitgeführt werden, sind über Funkverbindungen mit ortsfesten Stationen 12, 14 und 16 gekoppelt. Die festen Stationen 12, 14 und 16 sind über Leitungen 13, 15 und 17 mit einer zentralen Station 10 verbunden, die den Anschluß an das drahtgebundene Fernsprechnetz 11 herstellt. Die beweglichen Stationen 1 bis 7 und die festen Stationen 12, 14 und 16 enthalten Steuereinrichtungen, um bedarfsweise eine Funkverbindung herzustellen oder auch zu wechseln, nämlich wenn beispielsweise sich die bewegliche Station 2 näher zur festen Station 14 bewegt und die vorhandene Funkverbindung zur festen Station 12 immer ungünstiger wird. In einem solchen Falle erfolgt automatisch dann ein Wechsel der Funkverbindung zwischen der beweglichen Station 2 zur festen Station 14. Ferner sind in den beweglichen Stationen 1 bis 7 und der zentralen Station 10 Einrichtungen vorhanden, die ein Sprachsignal einem umfangreichen Sprachcodierungsverfahren zur Erzeugung von Codewörtern nach dem sogenannten GSM-Standard unterwerfen, der beispielsweise in der eingangs genannten Zeitschrift "Frequenz" 42 (1988), Heft 2/3, Seiten 85 bis 93 beschrieben ist, und die Bits bestimmter Bitstellen der Codewörter werden in den beweglichen Stationen 1 bis 7 und in den festen Stationen 12, 14, 16 noch durch ein Prüfwort bzw. durch eine redundante Kanalcodierung codiert, um am Empfangsort eine gewisse Fehlerverschleierung zu ermöglichen. Mit den codierten Bits wird ein Hochfrequenzträger moduliert, wobei die codierten Bits in Bitblöcken übertragen werden. Da die Erfindung sich nicht auf die Steuereinrichtungen und die Sendeeinrichtungen bezieht, werden diese hier nicht näher erläutert.

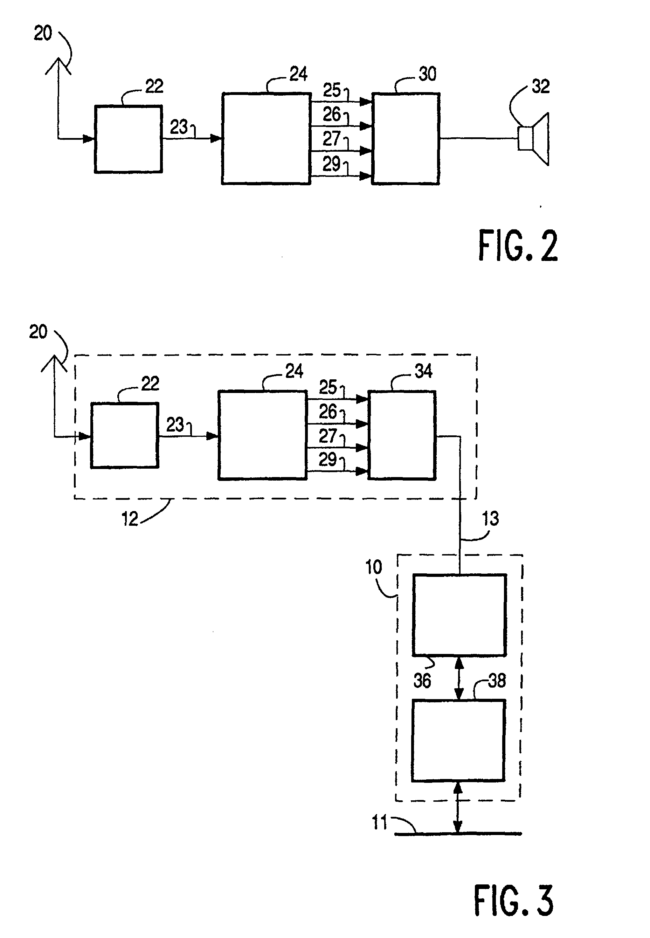

Ferner enthält jede bewegliche Station und jede feste Station eine Empfangsanordnung. In Fig. 2 ist sehr schematisch eine Empfangsanordnung einer beweglichen Station angedeutet. Diese umfaßt eine Antenne 20, die üblicherweise gleichzeitig Sendeantenne ist, und eine Empfängerschaltung 22 zum Verstärken und Demodulieren des Hochfrequenzsignals, und auf der Leitung 23 werden die demodulierten Kanalbits abgegeben. Diese werden einem Kanal-Decodierer 24 zugeführt, der aus den Kanalbits durch Fehlerkorrekturmaßnahmen wieder die Codewörter des empfangenen Bitblocks zurückgewinnt und am Ausgang 29 abgibt. Der Kanal-Decodierer 24 enthält z.B. einen Viterbi-Decodierer, der an einem weiteren Ausgang 25 einen Metrik-Wert zur Kennzeichnung der Zuverlässigkeit der decodierten Bits abgibt, wie beispielsweise in dem Buch von M. Bossert "Kanalcodierung" in der Buchreihe "Informationstechnik", B.G. Teubner, Stuttgart 1992, insbesondere im Kapitel 8.5 beschrieben ist. Ferner gibt der Kanal-Decodierer 24 ein Signal an einem Ausgang 26 ab, wenn in den Daten, die in den Kanalbits auf der Leitung 23 enthalten sind, mittels des Prüfworts ein Fehler erkannt worden ist. Schließlich gibt der Kanal-Decodierer 24 am Ausgang 27 noch einen Fehlerwert zur Kennzeichnung einer geschätzten Fehlerhäufigkeit in dem empfangenen Bitblock ab. Eine Möglichkeit für die Erzeugung eines solchen Fehlerwerts wird später erläutert.

Die Ausgänge des Kanaldecoders 24 führen auf eine Einheit 30, die hier in der beweglichen Station die Fehlerverschleierung und den Sprachdecoder zur Erzeugung der auszugebenden Sprachsignale umfaßt, die über den Lautsprecher 32 hörbar gemacht werden. Der Aufbau eines Sprachdecoders zur Erzeugung der Sprachsignale ist durch das Codierungsverfahren der Sprachsignale auf der Sendeseite bestimmt und ebenfalls aus der vorgenannten Druckschrift bekannt. Der grundsätzliche Aufbau einer Fehlerverschleierungsanordnung sowie die davon durchzuführenden Fehlerverschleierungsmaßnahmen werden später erläutert.

Fig. 3 zeigt ein grobes Blockschaltbild des gesamten Empfangspfades von einer ortsfesten Station, in diesem Fall der Station 12, und der damit verbundenen zentralen Station 10. Dieser Empfangspfad umfaßt in der ortsfesten Station 12 wieder eine Antenne 20 sowie einen Empfänger mit Demodulator 22, der die Hochfrequenzsignale verstärkt und demoduliert und als Kanalbits auf der Leitung 23 abgibt. Diese werden wieder einem Kanaldecoder 24 zugeführt, wobei die beiden Einheiten 22 und 24 im wesentlichen wie die entsprechenden Einheiten in Fig. 2 aufgebaut sind. In Fig. 3 schließt sich jedoch an den Kanaldecoder 24 bzw. an dessen Ausgänge 25 bis 27 und 29 eine Fehlerverschleierungsschaltung 34 an, die ebenfalls in der ortsfesten Station angeordnet ist. Diese Fehlerverschleierungsschaltung 34 führt alle Fehlerverschleierungsmaßnahmen an den vom Kanaldecoder 24 gelieferten Codewörtern durch und gibt nur Codewörter ab, die unmittelbar dem Sprachdecoder zugeführt und darin verarbeitet werden können. Diese modifizierten Codewörter werden über die Leitung 13, die die sogenannte Abis-Schnittstelle darstellt, dem Sprachdecoder 36 in der zentralen Station 10 zugeführt. Über diese Abis-Schnittstelle 13 laufen in bekannter Weise im Zeitmultiplex noch zusätzliche Steuersignale, zu denen auch ein Signal gehört, das angibt, ob eine übertragene Gruppe von Codewörtern fehlerfrei ist. Da die Modifikation von Codewörtern, soweit diese möglich ist, vollständig in der ortsfesten Station in der Fehlerverschleierungsschaltung 34 durchgeführt wird, hat dieses Fehlersignal ständig den logischen Wert "0", so daß im Sprachdecoder 36 in der zentralen Station 10 keine Fehlerverschleierungsmaßnahmen mehr durchgeführt werden, wie es bei den bisherigen Einrichtungen üblich war. Dabei sind keine Änderungen in dem Sprachdecoder 36 notwendig, es werden lediglich die Fehlerverschleierungsmöglichkeiten, die üblicherweise darin vorgesehen sind, nicht ausgenutzt.

Die decodierten Sprachsignale werden in der zentralen Station 10 einer Steuereinrichtung 38 zugeführt, die diese Sprachsignale auf das leitungsgebundene Fernsprechnetz 11 weiterleitet.

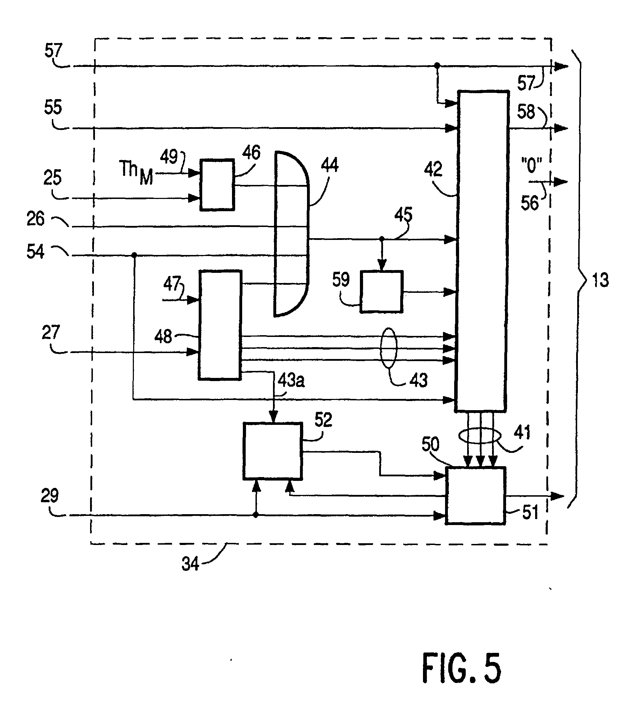

Der Aufbau eines Kanaldecoders 24 in Fig. 2 bzw. Fig. 3 ist in Fig. 4 etwas detaillierter dargestellt. Der Kern des Kanalcodierers 24 ist z.B. ein Viterbi-Decodierer 60, der die Kanalbits auf der Leitung 23 als Soft-Decision-Information, d.h. als Zuverlässigkeitsinformation empfängt und auf der Leitung 61 die decodierten Codewörter abgibt. Ein Teil der Kanalbits auf der Leitung 23 ist nicht kanalcodiert und wird dann von dem Decodierer 60 unverändert abgegeben. Außerdem gibt der Decodierer 60 auf der Leitung 25 einen Metrik-Wert ab, der eine Angabe der Zuverlässigkeit der decodierten Kanalbits auf der Leitung 61 darstellt.

Ein Teil der Bits eines Bitblocks ist auf der Sendeseite mit einem Prüfwort versehen, das drei Bit umfaßt und aus der Quersumme der Bitwerte einer Anzahl Bitstellen gewonnen wird. In der Prüfeinheit 72 wird für die decodierten Bits auf der Leitung 61 diese Quersumme wieder gebildet und mit den nachfolgenden drei Bits des Prüfworts verglichen. Bei fehlender Übereinstimmung wird auf der Leitung 26 ein Fehlersignal erzeugt.

In dem Strom der Kanalbits auf der Leitung 23 sind die Bits der Codewörter nicht in der richtigen Reihenfolge, sondern aus Gründen der möglichst optimalen Fehlersicherung verwürfelt enthalten. In der folgenden Fehlerverschleierungsanordnung und insbesondere im Sprachdecoder werden die Codewörter jedoch zusammenhängend benötigt, und dafür ist eine Sortiereinheit 70 vorgesehen, die die Bits der Codewörter wieder in die richtige Reihenfolge bringt und die vollständigen Codewörter aufeinanderfolgend auf der Leitung 29 abgibt.

Schließlich werden die decodierten Bits auf der Leitung 61 auch einem Kanalcodierer 62 zugeführt, der ebenso aufgebaut ist wie der Kanalcodierer der Sendeseite und im wesentlichen nur einige Verzögerungsglieder und einige Verknüpfungsglieder enthält. Damit muß, falls alle Übertragungsfehler korrigiert werden konnten oder bei fehlerfreier Übertragung, am Ausgang 63 des Kanalcodierers 62 dieselbe Bitfolge auftreten wie auf der Leitung 23, abgesehen von einer reinen Verzögerung durch den Kanaldecodierer 60 und den Kanalcodierer 62. Die Kanalbits auf der Leitung 23 werden nun in einer Verzögerungsstufe 65 um diese Zeitdauer verzögert, und beide Signalfolgen werden nun einem Vergleicher 64 zugeführt. Alle Bitstellen, an denen nicht übereinstimmende Bitwerte an beiden Eingängen des Vergleichers 64 auftreten, werden nun in einem Zähler 66 gezählt, und am Ende eines Bitblocks wird in einer Stufe 68 aus dem dann erreichten Zählwert des Zählers 66 ein Fehlerwert abgeleitet, insbesondere durch Normierung des Zählwertes mit einem festgelegten Normierwert, und der Fehlerwert wird auf der Leitung 27 abgegeben. Die Ausgänge des Kanal-Decodiers 24 sind nun mit einer Fehlerverschleierungsanordnung verbunden, die in Fig. 2 mit dem Sprachdecoder eine Einheit 30 bilden, jedoch in Fig. 3 eine getrennte Einheit 34 darstellt. Deren Aufbau ist in Fig. 5 näher angegeben.

Der Metrik-Wert auf der Leitung 25 führt darin auf einen Schwellwertvergleicher 46, wo dieser Metrik-Wert mit einem über die Leitung 49 zugeführten festen Schwellwert $TH_M$ verglichen wird. Dieser Schwellwert $TH_M$ liegt beispielsweise 4/5 oder 80 % des gesamten Bereichs aller möglichen Metrik-Werte von dem optimalen Metrik-Wert entfernt. Der Ausgang des Schwellwertvergleichers 46 führt auf einen Eingang eines ODER-Gatters 44, der auf einer Ausgangsleitung 45 einen Störindikator mit einem binären Wert liefert.

Die Leitung 26 für das Fehlersignal, das mittels des Prüfworts erzeugt wurde, führt auf einen weiteren Eingang des ODER-Gatters 44, von dem ein dritter Eingang mit einer Leitung 54 verbunden ist, die ein Signal führt, wenn ein empfangener Block nur Steuerinformation bedeutet und keine Sprachinformation enthält. Ein vierter Eingang des ODER-Gatters 44 ist mit einem Ausgang eines Schwellwertvergleichers 48 verbunden, der den Fehlerwert auf der Leitung 27 mit einer Anzahl Fehler-Schwellwerte vergleicht, die über einen Eingang 47 zugeführt werden. Der Schwellwertvergleicher 48 liefert ein Signal an das ODER-Gatter 44, wenn der Fehlerwert EV auf der Leitung 27 einen ersten Fehler-Schwellwert Th1 überschreitet. Th1 liegt beispielsweise bei 1000. Dabei ist angenommen, daß der Fehlerwert EV von dem Prozentsatz PE von Kanalbits, die als abweichend festgestellt wurden, bezogen auf die Gesamtzahl von Bits eines Bitblocks, auf folgende Weise abgeleitet wird

$$EV = \frac{PE}{100} \cdot 4096$$

so daß nur ganzzahlige Fehlerwerte EV weiterverarbeitet werden.

Die Ausgangsleitung 45 des ODER-Gatters, die den binären Störindikator führt, der nachfolgend mit BFI bezeichnet wird, führt zum einen auf einen Zwischenspeicher 59, der den BFI-Wert des jeweils vorhergehenden Bitblocks enthält, sowie auf eine Klassifizierschaltung 42, die verschiedene Fehlerklassen für den empfangenen Bitblock bildet und entsprechende Signale auf den Leitungen 41 an eine Codewortsteuerung 50 abgibt. Darin werden die über die Leitung 29 empfangenen Codewörter entsprechend den Fehlerklassen verarbeitet und am Ausgang 51 als modifizierte Codewörter abgegeben. Die Klassifizierschaltung 42 erhält noch weitere Signale, nämlich über die Leitungen 43 weitere Ausgangssignale von dem Schwellwertvergleicher 48 sowie den Störindikator des vorhergehenden Bitblocks von dem Zwischenspeicher 59, das Signal von der Leitung 54 sowie Signale von Leitungen 55 und 57. Das Signal auf der Leitung 55 ist dreiwertig und gibt an, ob der empfangene Bitblock mit Sicherheit, wahrscheinlich oder nicht ein Hintergrundgeräusch-Bitrahmen ist. Auf der Leitung 57 liegt ein Taktsignal, das in jedem 24. Bitblock einen Impuls führt.

Die Bildung der Fehlerklassen erfolgt nun abhängig von Bedingungen, die in der Tabelle angegeben sind.

TABELLE

| 54 | (BFI) | BFI | EV | Fehlerklasse |
|---|---|---|---|---|
| 0 | 0 | 0 | Th2≤EV<Th30 | 1 |

TABELLE   (fortgesetzt)

| 54 | (BFI) | BFI | EV | Fehlerklasse |
|---|---|---|---|---|
| 0 | 0 | 1 | EV<Th4 | 2 |
| 0 | 0 | 1 | EV≥Th4 | 3 |
| 0 | 1 | 0 | EV>Th5 | 2 |
| 0 | 1 | 1 | - | M |
| 1 | - | 1 | - | 3 |

Beispiele für die Fehlerschwellwerte sind Th2 = 700, Th3 = 1000, Th4 = 1500 und Th5 = 670.

Wenn der Störindikator nicht vorhanden ist bzw. BFI den Wert "0" hat, wird bereits die erste Fehlerklasse gebildet, wenn der Fehlerwert zwischen einem zweiten und einem dritten Fehler-Schwellwert Th2 und Th3 liegt, wobei dieser dritte Fehler-Schwellwert beispielsweise gleich dem vorher genannten ersten Fehler-Schwellwert Th1 ist, oberhalb dem über den Schwellwertvergleicher 48 und das ODER-Gatter 44 ein Störindikator erzeugt wird. Wenn der Störindikator jedoch vorhanden ist, d.h. BFI=1, wird die zweite Fehlerklasse gebildet, wenn der Fehlerwert EV unterhalb eines vierten Fehler-Schwellwertes Th4 liegt, weil dann noch Teile des empfangenen Bitblocks verwendet werden können, während die dritte Fehlerklasse gebildet wird, wenn der Fehlerwert diesen vierten Fehler-Schwellwert Th4 überschreitet oder gleich diesem ist. In all diesen Fällen wird angenommen, daß der Störindikator im vorhergehenden Bitblock nicht vorhanden war, d.h. (BFI)=0, wobei (BFI) den Störindikator im vorhergehenden Bitblock angibt, der in dem Zwischenspeicher 59 in Fig. 5 gespeichert ist. Wenn dagegen im vorhergehenden Bitblock der Störindikator vorhanden war, jedoch nicht im momentanen Bitblock, wird geprüft, ob der Fehlerwert unterhalb eines fünften Fehler-Schwellwertes Th5 liegt. Nur wenn dies der Fall ist, werden die Codewörter des empfangenen Bitblocks unverändert verarbeitet, anderenfalls wird die zweite Fehlerklasse gebildet. Wenn in jedoch in zwei aufeinanderfolgenden Bitblöcken der Störindikator vorhanden ist, wird eine schrittweise Stummschaltung eingeleitet, die unter der Fehlerklasse mit "M" angegebenen ist. Schließlich wird, wenn auf der Leitung 54 ein Signal vorhanden ist, das den empfangenen Bitblock als Steuerinformation ohne Sprachinformation kennzeichnet, wobei dann auch BFI=1 ist, wird die dritte Fehlerklasse gebildet, da von einem solchen Bitblock selbstverständlich keine Teile für die Erzeugung von Sprachsignalen verwertet werden können.

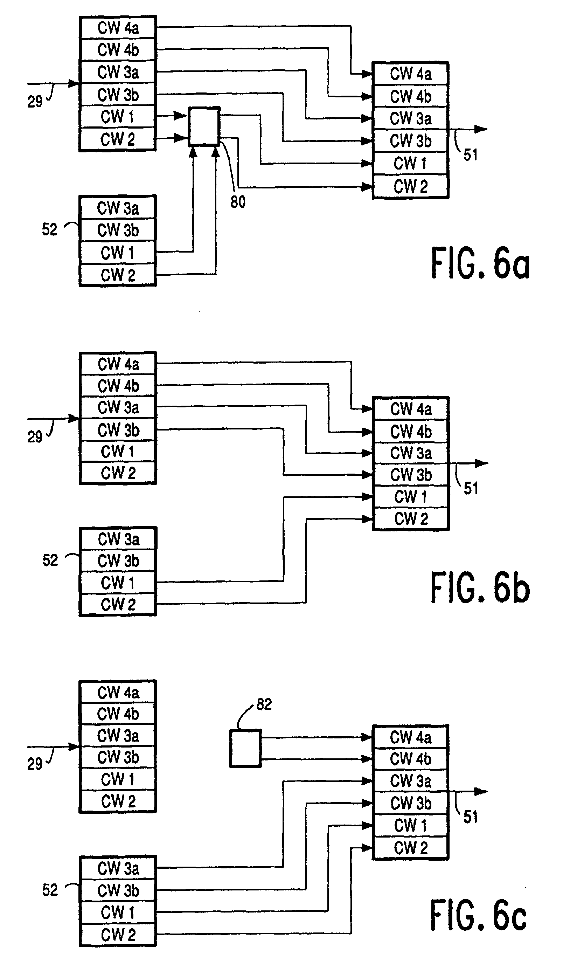

Wenn keine Fehlerklasse gebildet wird, werden in der Codewortsteuerung 50 in Fig. 5 die über die Leitung 29 zugeführten Codewörter am Ausgang 51 unverändert abgegeben. Die für die einzelnen Fehlerklassen durchzuführenden Fehlerverschleierungsmaßnahmen werden nachfolgend anhand der Fig. 6a bis 6f erläutert. Darin stellt der linke obere Block die empfangenen Codewortgruppen dar, wobei die erste Codewortgruppe CW1 LPC-Filterkoeffizienten, die zweite Codewortgruppe CW2 Amplitudenwerte, die dritte Codewortgruppe, die aus zwei Untergruppen CW3a und CW3b besteht, Langzeitkoeffizienten und die vierte Codewortgruppe, die ebenfalls aus zwei Untergruppen CW4a und CW4b besteht, codierte Restsignale des Sprachsignals auf der Sendeseite darstellen. Der linke untere Block stellt in einem Speicher 52 in Fig. 5 gespeicherte Codewortgruppen des vorhergehenden Bitblocks oder auch eines weiter zurückliegenden Bitblocks dar, denn in diesen Speicher 52 werden auf der Leitung 29 ankommende Codewörter eines Bitblocks nur dann eingeschrieben, wenn der Fehlerwert für diesen Bitblock kleiner als ein siebter Fehlerschwellwert Th7 ist, also EV<Th7. Ein typischer Wert hierfür ist Th7 = 750. Dieser Speicher 52 enthält jedoch nur die ersten drei Codewortgruppen, die vierte Codewortgruppe eines früheren Bitblocks wird nämlich für die hier verwendeten Fehlerverschleierungsmaßnahmen nicht benötigt, wie aus der folgenden Beschreibung hervorgeht. Der rechte Block in den Fig. 6a bis 6f stellt die modifizierten Codewortgruppen dar, die über den Ausgang 51 abgegeben werden.

Erste Fehlerklasse, Fig. 6a.

Von den empfangenen Codewörtern werden nur die Codewortgruppen CW3a,b und CW4a,b unbedingt unverändert weitergeleitet, während die ersten beiden Codewortgruppen CW1 und CW2 in dem Block 80 zunächst überprüft und abhängig von der Prüfung weitergeleitet werden. Wenn nämlich in der ersten Codewortgruppe die decodierten Koeffizienten (Reflexionskoeffizienten) mit Werten nahe +1,0 oder -1,0 auftreten, können unkontrollierte Schwingungen im Ausgangssignal auftreten. Daher wird für den Absolutwert dieser Koeffizienten ein Schwellwert Thr eingeführt. Thr liegt beispielsweise bei 0,96.

Bei der zweiten Codewortgruppe CW2 werden die darin enthaltenen Amplitudenwerte mit einem Mittelwert verglichen, der aus den Amplitudenwerten der zweiten Codewortgruppe des vorhergehenden Bitblocks aus dem Speicher 52 gebildet wird. Jeder neue Amplitudenwert, der von diesem Amplitudenmittelwert zu sehr abweicht, nämlich für den die Differenz zu diesem Amplitudenmittelwert $\geq D_{max}$ (ein typischer Wert ist beispielsweise $D_{max}$ = 16) ist, wird durch diesen Amplitudenmittelwert ersetzt. Bei geringerer Abweichung wird der betreffende Amplitudenwert aus der ersten Codewortgruppe des neuen Bitblocks unmittelbar weitergeleitet.

Zweite Fehlerklasse, Fig. 6b.

Hierbei wird keine Entscheidung mehr getroffen, sondern es wird die erste und die zweite Codewortgruppe des vorhergehenden Bitblocks aus dem Speicher 52 verwendet und die dritte und die vierte Codewortgruppe des momentanen Bitblocks unverändert übernommen und am Ausgang 51 abgegeben.

Dritte Fehlerklasse, Fig. 6c.

In diesem Falle werden überhaupt keine Teile der Codewörter des zuletzt empfangenen Bitblocks verwendet, sondern es wird die erste, die zweite und die dritte Codewortgruppe aus dem Speicher 52 übernommen, und als vierte Codewortgruppe werden Zufallswerte aus einem Zufallsgenerator 82 übernommen. Der Zufallsgenerator 82 kann auch aus einem Speicher bestehen, der eine begrenzte Anzahl Zufallswerte enthält und aus dem diese Zufallswerte in zyklischer Folge entnommen werden.

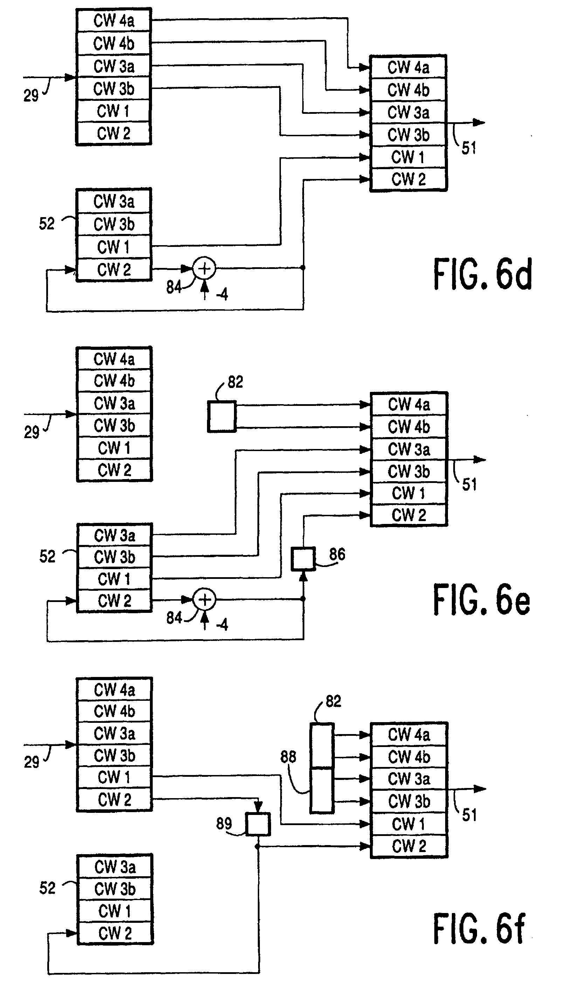

Stummschaltung, Fig. 6d und 6e.

Wenn zwei oder mehr aufeinanderfolgende Bitblöcke eintreffen, in denen jeweils der Störindikator vorhanden ist, wird eine schrittweise Stummschaltung vorgenommen. Dafür wird zunächst jeder Bitblock geprüft, ob für ihn die zweite oder die dritte Fehlerklasse gebildet wird. Im Falle der zweiten Fehlerklasse sind die Vorgänge bei der Stummschaltung in Fig. 6d dargestellt. Diese entspricht weitgehend Fig. 6b, d.h. die dritte und die vierte Codewortgruppe wird von dem momentan empfangenen Bitblock übernommen, während die erste Codewortgruppe aus dem Speicher 52 übernommen wird. Bei der zweiten Codewortgruppe wird dagegen in der Einheit 84 von allen Amplitudenwerten der Wert 4 subtrahiert, und diese Ergebnisse werden nicht nur als zweite Codewortgruppe für die Ausgabe am Ausgang 51 übernommen, sondern auch in den Speicher 52 zurückgeschrieben. Es ist klar, daß auf diese Weise bei einer längeren Folge von Bitblöcken, bei denen der Störindikator BFI=1 ist, die Amplituden schließlich den Wert 0 erreichen. Bei der Stummschaltung wird daher tatsächlich zunächst stets geprüft, ob alle Amplitudenwerte den Wert 0 haben, und wenn dies der Fall ist, werden nur noch die Codewörter eines fest gespeicherten Ruherahmens über den Ausgang 51 abgegeben.

Falls für den wiederholt gestört empfangenen Bitblock die dritte Fehlerklasse gebildet wird, werden die Fehlerverschleierungsmaßnahmen entsprechend Fig. 6e durchgeführt. Dabei wird von dem zuletzt empfangenen Bitblock kein Codewort mehr benutzt, sondern die erste und die dritte Codewortgruppe werden aus dem Speicher übernommen, die vierte Codewortgruppe wird durch Zufallswerte aus dem Zufallsgenerator 82 ersetzt, und bei der zweiten Codewortgruppe wird von allen Amplitudenwerten der Wert 4 subtrahiert. Die so erhaltenen reduzierten Amplitudenwerte werden jedoch nicht direkt verwendet, sondern in einem Block 86 wird der maximale und der minimale reduzierte Amplitudenwert unterdrückt, und aus den übrigen Amplitudenwerten wird der Mittelwert gebildet, und dieser Mittelwert wird für alle Amplitudenwerte des zweiten Codewortes eingesetzt. Ferner wird die zweite Codewortgruppe mit allen reduzierten Amplitudenwerten wieder in den Speicher 52 eingeschrieben. Damit stehen alle reduzierten Amplitudenwerte zur Verfügung, wenn z.B. beim nächsten gestört empfangenen Bitblock nur die zweite Fehlerklasse gebildet wird. Auch bei der Stummschaltung mit den Fehlerverschleierungsmaßnahmen gemäß Fig. 6e wird, wenn die Amplitudenwerte alle den Wert 0 erreicht haben, über den Ausgang 51 der sogenannte Ruherahmen abgegeben.

Wie bereits erwähnt, wird im Falle von Sprachpausen, in denen also keine echte Sprachinformation übertragen werden muß, am Ende des Sprachsignals oder genauer ausgedrückt, wenn vier Zeitabschnitte lang kein Sprachsignal festgestellt worden ist, ein Hintergrundgeräusch-Bitblock übertragen und danach für etwa eine halbe Sekunde der Sender abgeschaltet. Wenn die Sprachpause länger andauert, wird jeweils wiederholt alle halbe Sekunde ein Hintergrundgeräusch-Bitblock übertragen. Aus jedem Hintergrundgeräusch-Bitblock wird empfangsseitig für den entsprechenden Zeitabschnitt von etwa einer halben Sekunde ein Hintergrundgeräusch erzeugt, das dem tatsächlichen Hintergrundgeräusch sehr ähnlich ist und das dem Hörer anzeigt, daß die Verbindung noch besteht, jedoch die Gegenseite momentan lediglich nicht spricht. Dieses Hintergrundgeräusch soll einen angenehmen Übergang zum vorhergehenden Sprachsignal bilden und entspricht daher ungefähr einem Rauschen mit einem bestimmten Frequenzspektrum. Aus diesem Grunde brauchen die dritte und die vierte Codewortgruppe im Hintergrundgeräusch-Bitblock nicht übertragen zu werden, sondern die dritte Codewortgruppe wird durch fest vorgegebene Werte ersetzt und die vierte Codewortgruppe besteht wieder aus Zufallswerten. Dies ist in Fig. 6f angedeutet, wo die Zufallswerte für die vierte Codewortgruppe wieder von einem Zufallsgenerator 82 geliefert werden, während die festen Werte für die dritte Codewortgruppe aus einer entsprechenden Quelle 88 geliefert werden. Von den ersten beiden Codewortgruppen, die im empfangenen Hintergrundgeräusch-Bitblock enthalten waren, wird die erste Codewortgruppe unverändert verwendet, während aus der zweiten Codewortgruppe die Amplitudenwerte im Block 89 verarbeitet werden, der analog dem Block 86 in Fig. 6e bei der Stummschaltung für die dritte Fehlerklasse arbeitet. Dabei wird also der maximale und der minimale Amplitudenwert unterdrückt bzw. gleich Null gesetzt, und aus den restlichen Amplitudenwerten wird ein Mittelwert gebildet. Dieser Mittelwert wird für die Amplitudenwerte der zweiten Codewortgruppe eingesetzt und über den Ausgang 51 übertragen und außerdem in den Speicher 52 übertragen. Durch die Mittelwertbildung nach Unterdrückung der extremen Werte wird zuverlässig vermieden, daß durch kleine, nicht festgestellte Fehler im empfangenen Hintergrundgeräusch-Bitblock ein zu lautes oder zu leises Hintergrundgeräusch erzeugt wird.

Im übrigen wird auch ein Hintergrundgeräusch-Bitblock auf Störungen geprüft, insbesondere wird der Störindikator BFI in der vorher beschriebenen Weise gebildet, und der Fehlerwert wird mit einem sechsten Fehler-Schwellwert Th6 verglichen, der etwa bei dem zweiten Fehler-Schwellwert Th2 liegt, von dem an die erste Fehlerklasse gebildet wird. Außerdem ist das Signal zur Anzeige, daß ein empfangener Bitblock als Hintergrundgeräusch-Bitblock erkannt worden ist, dreiwertig, wobei die drei möglichen Werte einen zuverlässig erkannten Hintergrundgeräusch-Bitblock, einen als wahrscheinlich Hintergrundgeräusch-Bitblock erkannten Bitblock und einen nicht als Hintergrundgeräusch-Bitblock erkannten Bitblock angeben. Wenn nun in einem zuverlässig erkannten Hintergrundgeräusch-Bitblock der Fehlerwert den genannten Fehler-Schwellwert überschreitet oder der Störindikator vorhanden ist, oder der Hintergrundgeräusch-Bitblock ist nur als wahrscheinlich erkannt, werden die ersten beiden Codewörter nicht wie in Fig. 6f angedeutet aus dem gerade empfangenen Bitblock verwendet, sondern es werden die im Speicher 52 gespeicherten ersten beiden Bitblöcke übernommen und zusammen mit den aus den Blöcken 82 und 88 gelieferten Werten am Ausgang 51 abgegeben. Dabei wird der Inhalt des Speichers 52 nicht verändert.

Wie bereits erwähnt, werden in längeren Sprachpausen die Hintergrundgeräusch-Bitblöcke nur etwa alle halbe Sekunde übertragen, und zwar zusammen mit einem Taktsignal, das an einer besonderen Stelle in jedem 24. Bitblock codiert ist. Dadurch kann der zweite Hintergrundgeräusch-Bitblock auch kurz nach dem ersten übertragen werden, abhängig davon, wie das Sprachsignal in Beziehung zum Taktsignal geendet hat.

Es muß berücksichtigt werden, daß auch ein Hintergrundgeräusch-Bitblock so stark bei der Übertragung gestört sein kann, daß er im Empfänger nicht mehr als solcher erkennbar ist. Da andererseits, wie vorher ausgeführt, ein wiederholter Hintergrundgeräusch-Bitblock nur zusammen mit einem Taktsignal alle 24 Bitblöcke übertragen wird, wird nun nach einem Hintergrundgeräusch-Bitblock in einem Bitblock mit Taktsignal abgewartet, ob nach einer Zeitperiode von 25 Bitblöcken wieder ein Hintergrundgeräusch-Bitblock erkannt wird. Wenn dies nicht der Fall ist, sondern es sind nur Bitblöcke mit Störindikator BFI=1 empfangen worden, wird auch hier eine Stummschaltung eingeleitet. Diese wird für die erste und zweite Codewortgruppe in der gleichen Weise durchgeführt, wie es in Fig. 6d dargestellt ist, während für die dritte und die vierte Codewortgruppe die Werte der Blöcke 82 und 88 weiterhin verwendet werden. Wenn bei dieser Stummschaltung schließlich alle Amplitudenwerte gleich Null sind, wird der Ausgang 51 auf den bereits erwähnten Ruherahmen umgeschaltet.

Wenn andererseits nach einem gegebenenfalls wiederholt übertragenen Hintergrundgeräusch-Bitrahmen ein Bitrahmen empfangen wird, der nicht als Hintergrundgeräusch-Bitblock erkennbar ist, bei dem jedoch der Störindikator BFI=0 ist, muß es sich um einen Bitblock mit echten Sprachdaten handeln, und in diesem Falle wird unmittelbar auf Sprachdecodierung zurückgeschaltet.

Es werden also in allen Empfangssituationen Blöcke mit eindeutigen Codewörtern erzeugt, bei denen eine weitere Fehlerverschleierungsmöglichkeit nicht mehr vorhanden ist, da diese bereits in der Codewortsteuerung 50 in Fig. 5 durchgeführt wurde. Die verschiedenen Fehlerverschleierungsvorgänge werden über die Leitungen 41 von der Klassifizierschaltung 42 gesteuert, und zwar auch im zuletzt beschriebenen Fall der Hintergrundgeräusch-Bitblöcke, da die Klassifizierschaltung 42 über die Leitung 55 auch die Angabe erhält, ob es sich um einen sicheren oder wahrscheinlichen Hintergrundgeräusch-Bitblock handelt, und über die Leitung 57 wird das Taktsignal zugeführt, das im jeden 24. Bitblock auftritt. Die am Ausgang 51 abgegebenen Codewörter können also unmittelbar von dem Sprachdecoder verarbeitet werden. Die in Fig. 5 dargestellte Fehlerverschleierungsschaltung 34 wird jedoch in der festen Station angenommen, wie früher erwähnt wurde, wobei der Sprachdecoder in der zentralen Station 10 in Fig. 1 bzw. Fig. 3 angeordnet ist. Die Übertragung der Codewörter zu dieser zentralen Station erfolgt über die bereits erwähnte Abis-Schnittstelle, über die bei bereits vorhandenen Stationen eine Kennzeichnung erwartet wird, ob es sich bei den übertragenen Codewörtern um Hintergrundgeräusch-Codewörter handelt, die in Fig. 5 über die Leitung 58 übertragen wird, außerdem das Taktsignal auf der Leitung 57, das ebenfalls bei bekannten Stationen erwartet wird. Ferner wird im Sprachdecoder ein Signal erwartet, ob die übertragenen Codewörter fehlerfrei sind, da bei bisher vorhandenen Stationen die Fehlerverschleierung im Sprachdecoder durchgeführt werden soll. Da in diesem Falle aber nur fehlerfreie Codewörter übertragen werden, wird über eine Leitung 56 ständig der Wert "0" abgegeben, um dem Sprachdecoder in der zentralen Station zu signalisieren, daß nur fehlerfreie Codewörter übertragen werden. Damit ist für den Sprachdecoder in der zentralen Station keine Änderung notwendig, um mit einer Fehlerverschleierungsschaltung entsprechend der Fig. 5 zusammen zu arbeiten.

**Patentansprüche**

1.  Schaltungsanordnung zum Empfang von Bitblöcken, von denen jeder aus Sprachsignalen eines Zeitabschnitts vorgegebener Dauer gebildet ist, mit einem Empfangsteil (22) zum Empfangen und Demodulieren von ausgesandten Bitblöcken zur Erzeugung von Kanalbits,
einem Kanaldecoder (24) zum Erzeugen von unterschiedlichen Codewörtern aus den Kanalbits an einem Kanalausgang (29), wobei Bits an vorgegebenen Bitstellen der Codewörtern durch ein Prüfwort gesichert sind und
einer mit dem Kanalausgang (29) gekoppelten Fehlerverschleierungsschaltung (30, 34) mit einem Speicher (52) zur Speicherung der Codewörter eines vorherigen Bitblocks und
einem Sprachdecoder (30, 36) zum Erzeugen von Sprachsignalen aus zugeführten Codewörtern,
**dadurch gekennzeichnet,**
**dass** Mittel zur Erzeugung von Fehlersignalen aus den Kanalbits vorgesehen sind, wobei die Fehlersignale ein Ausmaß von Störungen in einem empfangenen Bitblock und/oder aus diesem Bitblock gebildeten Prüfwort angeben und zur Zuführung zur Fehlerverschleierungsschaltung (30, 34) vorgesehen sind, und in der Fehlerverschleierungsschaltung (30, 34) in Abhängigkeit der Fehlersignale die Erzeugung von Fehlerklassensignalen vorgesehen ist, wobei eine Fehlerklasse von einem Fhlerwert und entweder einem Prüfwortfehlersignal oder einem Störsignal bestimmt ist, wobei mittels der Fehlerklassensignale eine Modifizierung der Codewörter des empfangenen Bitblocks in unterschiedlicher Weise vorgesehen ist.

2. Schaltungsanordnung nach Anspruch 1 **dadurch gekennzeichnet,**
**daß** der Kanaldecoder (24) einen ersten, zweiten und dritten Fehlerausgang (25,26,27) aufweist, die zur Abgabe von Fehlersignalen und zur Zuführung zur Fehlerverschleierungsschaltung (30, 34) vorgesehen sind, und in der Fehlerverschleierungsschaltung (30, 34) vorgesehen ist, in Abhängigkeit der Fehlersignale in einer Klassifizierschaltung Fehlerklassensignale für unterschiedliche Fehler der Codewortgruppen zu erzeugen.

3. Schaltungsanordnung nach Anspruch 1 **dadurch gekennzeichnet,**
**daß** der Kanaldecoder (24) eingerichtet ist, um am Kanalausgang (29) eine erste, eine zweite, eine dritte und eine vierte Codewortgruppe abzugeben, wobei die erste Codewortgruppe Filterkoeffizienten, die zweite Codewortgruppe Amplitudenwerte, die dritte Codewortgruppe Langzeit-Koeffizienten und die vierte Codewortgruppe einzelne codierte Restsignale des Sprachsignals für eine Rekonstruktion von auszugebenden Sprachsignalen angibt.

4. Schaltungsanordnung nach Anspruch 1 **dadurch gekennzeichnet,**
**daß** der Kanaldecoder (24) eingerichtet ist, an einem ersten Fehlerausgang (26) ein Prüfwortfehlersignal aus jedem Bitblock zu erzeugen, wobei das Prüfwortfehlersignal von einem in dem empfangenen Bitblock enthaltenen Prüfwort abgeleitet ist.

5. Schaltungsanordnung nach Anspruch 4,
**dadurch gekennzeichnet,**
**dass** zur Erzeugung eines Fehlerwerts an einem zweiten Fehlerausgang (27) eine Codierschaltung (62) zum Erzeugen von kanal-codierten Hilfssignalen aus den decodierten Kanalbits vorgesehen ist und ein Vergleicher (64) zum Vergleichen der Hilfssignale mit entsprechenden Kanalbits des Empfangsteils (22) und zum Erzeugen von Fehlersignalen bei fehlender Übereinstimmung, einen Zähler (66) zum Zählen der Fehlersignale und eine mit dem Zähler (66) gekoppelte Auswerteschaltung (68) zum Erzeugen des Fehlerwerts an dem zweiten Fehlerausgang (27) enthält.

6. Schaltungsanordnung nach Anspruch 5,
**dadurch gekennzeichnet,**
**dass** der Kanaldecoder (24) eingerichtet ist, um an einem dritten Fehlerausgang (25) das Störsignal für eine Angabe eines wahrscheinlichen Ausmaßes von Störungen im empfangenen Bitblock zu erzeugen.

7. Schaltungsanordnung nach Anspruch 2,
**dadurch gekennzeichnet,**
**dass** die Fehlerverschleierungsschaltung (30, 34) einen

- ersten Schwellwertvergleicher (48) zum Vergleichen des Fehlerwerts von einem zweiten Fehlerausgang (27) mit mehreren Fehler-Schwellwerten (47) und einen
- zweiten Schwellwertvergleicher (46) enthält, um das Störsignal von einem dritten Fehlerausgang (25) mit einem Stör-Schwellwert zu vergleichen,

und eine wenigstens mit einem ersten Fehlerausgang (26) gekoppelte

- Störindikatorschaltung (44) aufweist, um abhängig wenigstens vom Prüfwortfehlersignal ein Störindikatorsignal (45) zu erzeugen, und dass die Störindikatorschaltung (44) eine

- Verknüpfungsschaltung enthält, um durch logische Verknüpfung eines Ausgangssignals des ersten Schwellwertvergleichers (48), eines Ausgangssignals des zweiten Schwellwertvergleichers (46) und des Prüfwortfehlersignals vom ersten Fehlerausgang (26) das Störindikatorsignal zu erzeugen

und eine

- Klassifizierschaltung (42) vorgesehen ist, die mit dem ersten Schwellwertvergleicher (48) gekoppelt ist, um abhängig von einem überschrittenen Fehler-Schwellwert und dem Störindikatorsignal eines von einer Anzahl unterschiedlicher Fehlerklassensignale zu erzeugen, und eine von den Fehlerklassensignalen angesteuerte Codewortsteuerung (50) enthält, um abhängig von zugeführten Fehlerklassensignalen wenigstens einige der vom Kanaldecoder (24) abgegebenen Codewortgruppen zu modifizieren, insbesondere durch eine aus den Codewörtern des Speichers (52) abgeleitete Codewortgruppe zu ersetzen.

8. Schaltungsanordnung nach Anspruch 1 in einer ortsfesten Station, **dadurch gekennzeichnet, daß** in der ortsfesten Station (12, 14, 16) der Kanaldecoder (24) zur Erzeugung wenigstens der Fehlersignale eingerichtet ist und die Fehlerverschleierungsschaltung (34) zum Modifizieren der Codewörter des Kanaldecoders (24) abhängig von den Fehlersignalen in der ortsfesten Station (12, 14, 16) vorgesehen ist und der Sprachdecoder (36) und eine Steuereinrichtung (38) in einer zentralen Station (10) vorgesehen sind.

9. System mit wenigstens einer ortsfesten Station und wenigstens einer beweglichen Station zur Übertragung von Sprachsignalen zwischen der beweglichen Station (1 bis 7) und der ortsfesten Station (12, 14, 16), wobei jede Station einen Sendeteil zum Umsetzen der Sprachsignale eines Zeitabschnitts vorgegebener Dauer in mehrere aus Bits bestehende Codewortgruppen mit unterschiedlicher Bedeutung und zum Umsetzen der Bits in Kanalbits eines Kanalcodes und zum Aussenden der Kanalbits als Bitblock sowie eine Schaltungsanordnung nach einem der Ansprüche 1 bis 8 enthält.

10. Verfahren zur Übertragung von Sprachsignalen zwischen einer ortsfesten ersten Station und wenigstens einer beweglichen, zweiten Station, wobei die Sprachsignale eines vorgegebenen Zeitabschnitts in mehrere aus Bits bestehende Codewörter mit unterschiedlicher Bedeutung umgesetzt werden, wobei die wichtigsten Bits der Codewörter durch ein Prüfwort gesichert werden und die Bits der Codewörter in Kanalbits eines Kanalcodes umcodiert werden und als Bitblock ausgesendet werden, aus dem auf der Empfangsseite durch Kanal-Decodierung die Codewörter und Qualitätsmerkmale - zurückgewonnen werden, wobei bei Feststellung eines Fehlers mittels der Qualitätsmerkmale vorbestimmte Fehlerverschleierungsmaßnahmen zur Erzeugung modifizierter Codewörter ausgelöst werden und aus den Codewörtern oder bei Vorliegen eines Fehlers aus den modifizierten Codewörtern auszugebende Sprachsignale gebildet werden,
**dadurch gekennzeichnet,**
**dass** bei der Kanal-Decodierung als Qualitätsmerkmale Informationen über Fehlereigenschaften der empfangenen Bitblöcke erzeugt werden, wobei die Informationen aus den Bitblöcken und aus dem aus den Bitblöcken gebildeten Prüfwort gebildet werden und dass abhängig von diesen Informationen Fehlerklassen gebildet werden, die durch einen Fehlerwert und entweder ein Prüfwortfehlersignal oder ein Störsignal bestimmt werden und mittels derer die Codewörter in unterschiedlicher Weise modifiziert werden.

11. Verfahren nach Anspruch 10, **dadurch gekennzeichnet, daß**
vorgegebene Bits von Codewortgruppen sendeseitig zusammengefaßt mit einem Prüfwort versehen sind, das empfangsseitig zurückgewonnen wird,
und daß bei der Kanal-Decodierung ein Fehlerwert entsprechend einer geschätzten Bitfehlerhäufigkeit gebildet und mit mehreren Fehler-Schwellwerten verglichen wird und daß abhängig vom überschrittenen Fehler-Schwellwert und vom Wert eines Störindikators, der wenigstens von einem mittels des Prüfworts erkannten Fehler abhängt, eine von einer vorgegebenen Anzahl Fehlerklassen gebildet wird und für verschiedene Fehlerklassen wenigstens die ersten beiden Codewortgruppen modifiziert werden.

12. Verfahren nach Anspruch 10,
**dadurch gekennzeichnet, daß** ein Störindikator als ein binärer Wert gebildet wird, wenn wenigstens eine der folgenden Bedingungen erfüllt ist:

a) mittels des Prüfworts wird ein Fehler erkannt,

b) ein bei der Kanal-Decodierung gebildeter Metrikwert überschreitet einen vorgegebenen Metrik-Schwellwert,

c) der Fehlerwert überschreitet einen vorgegebenen ersten Fehler-Schwellwert.

**13.** Verfahren nach Anspruch 10 und 12, **dadurch gekennzeichnet,**

**daß** eine erste Fehlerklasse gebildet wird,

wenn bei fehlendem Störindikator der Fehlerwert zwischen einem zweiten und einem dritten Fehler-Schwellwert liegt, wobei für diese erste Fehlerklasse in einer ersten Codewortgruppe Angaben für wenigstens erste zwei Filterkoeffizienten mit Filterschwellwerten verglichen werden und bei Überschreiten dieser Filterschwellwerte durch wenigstens eine Angabe eine modifizierte erste Codewortgruppe durch die erste Codewortgruppe eines vorhergehenden gespeicherten Bitblocks gebildet wird und in einer zweiten Codewortgruppe jeder Amplitudenwert mit einem aus den Amplitudenwerten des vorhergehenden Bitblocks abgeleiteten Amplitudenmittelwert verglichen wird und bei Abweichung von diesem Amplitudenmittelwert um ein vorgegebenes Maß in der modifizierten Codewortgruppe durch diesen Amplitudenmittelwert ersetzt wird, und eine modifizierte dritte und vierte Codewortgruppe gleich einer entsprechenden empfangenen Codewortgruppe ist, daß eine zweite Fehlerklasse gebildet wird,

wenn bei vorhandenem Störindikator der Fehlerwert einen vierten Fehler-Schwellwert nicht überschreitet oder bei fehlendem Störindikator im vorhergehenden Bitblock der Störindikator vorhanden war und der Fehlerwert im momentanen Bitblock einen fünften Fehler-Schwellwert überschreitet, und für diese zweite Fehlerklasse die modifizierte erste und zweite Codewortgruppe die entsprechende gespeicherte Codewortgruppe des vorhergehenden Bitblocks ist und die modifizierte dritte und vierte Codewortgruppe gleich der entsprechenden empfangenen Codewortgruppe ist, und

**daß** eine dritte Fehlerklasse gebildet wird,

wenn bei vorhandenem Störindikator der Fehlerwert den vierten Fehler-Schwellwert überschreitet, wobei für diese dritte Fehlerklasse die modifizierte erste, zweite und dritte Codewortgruppe die entsprechende gespeicherte Codewortgruppe des vorhergehenden Bitblocks ist und die modifizierte vierte Codewortgruppe aus einen Zufallswert besteht.

**14.** Verfahren nach Anspruch 10 und 13,

**dadurch gekennzeichnet, daß** für einen Bitblock, der als Steuerwort ohne Sprachinformation erkannt wird, die Fehlerverschleierungsmaßnahmen entsprechend der dritten Fehlerklasse durchgeführt werden.

**15.** Verfahren nach Anspruch 10 bis 14, **dadurch gekennzeichnet,**

**daß** wenigstens beim Feststellen eines Fehlers mittels des Prüfworts in zwei aufeinanderfolgenden Bitblöcken die erste modifizierte Codewortgruppe die gespeicherte erste Codewortgruppe des vorhergehenden Bitblocks ist und die zweite modifizierte Codewortgruppe die um einen festen Betrag reduzierten Amplitudenwerte der gespeicherten zweiten Codewortgruppe enthält und die gespeicherte zweite Codewortgruppe durch das modifizierte zweite Codewort ersetzt wird, und

bei einem Bitblock, für den die zweite Fehlerklasse gebildet wird, die dritte und die vierte modifizierte Codewortgruppe die unveränderte entsprechende Codewortgruppe dieses Bitblocks ist und

**daß** bei einem Bitblock, für den die dritte Fehlerklasse gebildet wird, die zweite modifizierte Codewortgruppe für alle Amplitudenwerte einen Mittelwert, der aus den Amplitudenwerten der gespeicherten zweiten Codewortgruppe außer dem kleinsten und dem größten Amplitudenwert gebildet ist, enthält und die dritte modifizierte Codewortgruppe das gespeicherte dritte Codewortgruppe des vorhergehenden Bitblocks ist und die vierte modifizierte Codewortgruppe aus einen Zufallswert besteht.

**16.** Verfahren nach einem der Ansprüche 10 bis 15, **dadurch gekennzeichnet, daß** während Sprachpausen als Sprachsignal ein Hintergrundgeräusch erzeugt wird, das aus den ersten beiden Codewortgruppen eines Bitblocks, der als Hintergrundgeräusch-Bitblock **gekennzeichnet ist**, gebildet wird, und

für einen zuverlässig erkannten Hintergrundgeräusch-Bitblock, bei dem der Fehlerwert unterhalb eines vorgegebenen sechsten Fehler-Schwellwerts liegt, die modifizierte erste Codewortgruppe die empfangene erste Codewortgruppe ist und in der empfangenen zweiten Codewortgruppe die beiden extremsten Amplitudenwerte weggelassen und der Mittelwert der restlichen Amplitudenwerte für alle Amplitudenwerte in der modifizierten zweiten Codewortgruppe verwendet wird und daß für einen zuverlässig erkannten Hintergrundgeräusch-Bitblock, bei dem der Fehlerwert oberhalb des sechsten Fehler-Schwellwertes liegt oder bei dem der Störindikator vorhanden ist, oder für einen nicht zuverlässig erkannten Hintergrundgeräusch-Bitblock als modifizierte erste und zweite Codewortgruppe die in einem früheren Bitblock empfangene erste bzw. zweite Codewortgruppe verwendet wird.

**17.** Verfahren nach einem der Ansprüche 10 bis 16,

**dadurch gekennzeichnet, daß** der Fehlerwert dadurch gebildet wird, daß die kanaldecodierten Kanalbits erneut kanal-codiert werden und die erneut codierten Bits bitstellenrichtig mit den empfangenen Bits verglichen werden und Bitstellen mit unterschiedlichen Bitwerten zur Erzeugung eines Zählwertes gezählt werden und aus dem Zählwert der Fehler-wert abgeleitet wird.

18. Verfahren nach einem der Ansprüche 10 bis 17,
**dadurch gekennzeichnet, daß** für die von der beweglichen Station ausgesandten Bitblöcke die Fehlerverschleierungsmaßnahmen vollständig in der ortsfesten Station durchgeführt werden und nur als fehlerfrei gekennzeichnete Codewörter abgegeben werden.

**Claims**

1. A circuit arrangement for receiving bit blocks which are built from speech signals lasting a time slot of predefined duration, comprising a receiving part (22) for receiving and demodulating transmitted bit blocks for the generation of channel bits, a channel decoder (24) for generating different code words from the channels bits on a channel output (29), while bits are secured by a test word at predefined bit positions of the code words, and an error masking circuit (30, 34) coupled to the channel output (29), the circuit comprising a memory (52) for storing the code words of a previous bit block and a speech decoder (30, 36) for generating speech signals from received code words, **characterized in that** means are provided for generating error signals from the channel bits, the error signals indicating an extent of faults in a received bit block and/or a test word built from this bit block and to be applied to the error masking circuit (30, 34) and in the error masking circuit (30, 34) the generation of error class signals is provided in dependence on the error signals, an error class being determined by an error value and either a test word error signal or a fault signal, a modification of the code words of the received bit block being provided in different manners in dependence on the error class signals.

2. A circuit arrangement as claimed in claim 1, **characterized in that** the channel decoder (24) has a first, second and third error output (25, 26, 27) which is provided for issuing error signals and for applying them to the error masking circuit (30, 34), and in the error masking circuit (30, 34) there is provided to generate error class signals for different errors of the code word groups in dependence on the error signals in a classification circuit.

3. A circuit arrangement as claimed in claim 1, **characterized in that** the channel decoder (24) is arranged for producing on the channel output (29) a first, a second, a third and a fourth code word group, in which the first code word group denotes filter coefficients, the second code word group amplitude values, the third code word group dwell time coefficients and the fourth code word group individually coded rest signals of the speech signal for a reconstruction of speech signals to be produced.

4. A circuit arrangement as claimed in claim 1, **characterized in that** the channel decoder (24) is arranged for generating on a first error output (26) a test word error signal from each bit block while the test word error signal is derived from a test word contained in the received bit block.

5. A circuit arrangement as claimed in claim 4, **characterized in that** for generating an error value on a second error output (27) a coding circuit (62) is provided for generating channel coded auxiliary signals from the decoded channel bits and comprises a comparator (64) for comparing the auxiliary signals with respective channel bits of the receive part (22) and for generating error signals in case there is no correspondence, a counter (66) for counting the error signals and an evaluation circuit (68) coupled to the counter (66) for generating the error value on the second error output (27).

6. A circuit arrangement as claimed in claim 5, **characterized in that** the channel decoder (24) is arranged for generating on a third error output (25) the fault signal for an indication of a probable extent of faults in the received bit block.

7. A circuit arrangement as claimed in claim 2, **characterized in that** the error masking circuit (30, 34) comprises
a first threshold comparator (48) for comparing the error value from a second error output (27) with a plurality of error thresholds (47) and
a second threshold comparator (46) for comparing the fault signal from a third error output (25) with a fault threshold, and includes
a fault indicator circuit (44) coupled at least to a first error output (26) to generate a fault indicator signal (45) depending on at least the test word error signal,
and **in that** the fault indicator circuit (44) comprises
a combining circuit for generating the fault indicator signal via a logic combination of an output signal from the first threshold comparator (48), an output signal from the second threshold comparator (46) and the test word error signal from the first error output (26) and
a classification circuit (42) is provided which is coupled to the first threshold comparator (48) to generate one from a number of different error class signals in dependence on an exceeded error threshold and the fault indicator signal of one from a number of different error class signals, and includes

- a code word controller (50) triggered by the error class signals to modify at least several of the code word groups produced by the channel decoder (24) in dependence on applied error class signals, more particularly by replacing a code word group derived from the code word groups from the memory (52).

8. A circuit arrangement as claimed in claim 1 in a base station, **characterized in that** in the base station (12, 14, 16) the channel decoder (24) is arranged for generating at least the error signals and the error masking circuit (34) is provided for modifying the code words of the channel decoder (24) in dependence on the error signals in the base station (12, 14, 16) and the speech decoder (36) and the controller (38) are provided in a central station (10).

9. A system comprising at least a base station and at least a mobile station for transmitting speech signals between the mobile station (1 to 7) and the base station (12, 14, 16), each station comprising a transmitting part for converting the speech signals of a time slot of predefined length into a plurality of code word groups consisting of bits, which groups have different meanings and for converting the bits into channel bits of a channel code and for transmitting the channel bits as one bit block as well as the circuit arrangement as claimed in one of the claims 1 to 8.

10. A method of transmitting speech signals between a stationary first station and at least one mobile second station, in which the speech signals of a given time slot are converted to several multi-bit code words having different connotations, while the most significant bits of the code words are secured by a test word and the bits of the code words are recoded into channel bits of a channel code and are transmitted as bit blocks from which the code words and quality features are recovered at the receiving end by channel decoding, error masking measures for generating modified code words being triggered when an error is detected by means of the quality features and output speech signals being formed from the code words or in event of an error from the modified code words, **characterized in that** information items about error properties of the received bit blocks are generated as quality features during the channel decoding, the information items being formed from the bit blocks and from the test words formed by the bit blocks and **in that** error classes are formed from these information items, which error classes are determined by an error value and either a test word error signal or a fault signal and by means of which values the code words are modified in different manners.

11. A method as claimed in claim 10, **characterized in that** predefined bits of code word groups are collectively provided with a test word at the transmitting end, which test word is recovered at the receiving end and **in that** during the channel decoding an error value is formed with an estimated bit error rate and is compared with a plurality of error thresholds and **in that** in dependence on the exceeded error threshold and on the value of a fault indicator which depends on at least one error detected by means of the test word, one of a number of predefined error classes is formed and for several error classes at least the first two code word groups are modified.

12. A method as claimed in claim 10, **characterized in that** a fault indicator is formed as a binary value if at least one of the following conditions is satisfied:

an error is detected via the test word,
a metric value formed during the channel decoding exceeds a given metric threshold,
the error value exceeds a predefined first error threshold.

13. A method as claimed in claims 10 and 12, **characterized in that** a first error class is formed
if the error value lies between a second and a third error threshold if the binary fault indicator is lacking and for this error class in a first code word group indications for at least the first two filter coefficients are compared with filter thresholds and, if at least one indication exceeds this filter threshold, a modified first code word group is formed by the first code word group of a previous stored bit block and in a second code word group each amplitude value is compared with an amplitude value derived from the amplitude values of the previous bit block and in the case of a deviation from this average amplitude value to a predefined extent in the modified code word group, is replaced by this average amplitude value, and a modified third and fourth code word group is equal to a corresponding received code word group,

**in that** a second error class is formed,

if the error value of the available fault indicator does not exceed a fourth error threshold or, if the fault indicator is lacking the fault indicator was available in the previous bit block and the error value in the current bit block exceeds a fifth error threshold and for this second error class the modified first and second code word group is the respective corresponding stored code word group of the previous bit block and the modified third and fourth code word group is equal to the respective corresponding received code word group, and

**in that** a third error class is formed

if the error value of the available fault indicator exceeds the fourth error threshold while for this third error class the modified first, second and third code word groups are the respective stored code word groups of the previous bit block and the modified fourth code word group consists of a random value.

14. A method as claimed in claims 10 and 13, **characterized in that** for a bit block that is detected as the control word without speech information, the error masking measures are carried out in accordance with the third error class.

15. A method as claimed in claims 10 to 14, **characterized in that** at least when an error is detected by means of the test word in two consecutive bit blocks, the first modified code word group is the stored first code word group of the previous bit block and the second modified code word group contains the amplitude value of the stored second code word group reduced by a fixed amount, and the stored second code word group is replaced by the modified second code word, and in case of a bit block for which the second error class is formed, the third and fourth modified code word group is the unchanged respective code word group of this bit block, and **in that** with a bit block for which the third error class is formed, the second modified code word group contains for all amplitude values a mean value which is formed from the amplitude values of the stored second code word group with the exception of the smallest and largest amplitude value and the third modified code word group is the stored third code word group of the previous bit block and the fourth modified code word group is a random value.

16. A method as claimed in one of the claims 10 to 15, **characterized in that** during speech pauses the speech signal is generated as background noise, which background noise is formed from the first two code word groups of a bit block which is featured as background noise bit block and for a reliable detection of a background noise bit block in which the error value lies below a predefined sixth error threshold, the modified first code word group is the received first code word group the two extreme amplitude values have been omitted from the received second code word group and the average value of the remaining amplitude values is used for all the amplitude values in the modified second code word group and **in that** for a reliably detected background noise bit block in which the error value lies above the sixth error threshold or in which the fault indicator is present, or for a non-reliably detected background noise bit block, the first or second code word group received in a previous bit block is used as a modified first and second code word group.

17. A method as claimed in one of the claims 10 to 16, **characterized in that** the error value is formed **in that** the channel-decoded channel bits are again channel coded and the recoded bits are compared with the received bits as regards bit positions and bit positions having different bit values are counted to produce a count and the error value is derived from the count.

18. A method as claimed in one of the preceding claims 10 to 17, **characterized in that** for the bit blocks sent from the mobile stations the error masking measures are implemented integrally in the base station and are only produced as error-free code words.

**Revendications**

1. Circuit de réception de blocs de bits à partir desquels est formé chacun des signaux de parole d'un segment temporel de durée préalablement déterminée, avec une partie de réception (22) pour la réception et la démodulation de blocs de bits transmis pour la production de bits de canal, un décodeur de canal (24) pour la production des différents mots de code à partir des bits de canal à une sortie de canal (29), les bits dans des positions binaires préalablement déterminées des mots de code étant protégés par un mot de contrôle et

un circuit de masquage des erreurs (30, 34) couplé à la sortie de canal (29) avec une mémoire (52) pour l'enregistrement des mots de code d'un bloc de bits précédent et un décodeur de paroles (30, 36) pour la production de signaux de parole à partir des mots de code amenés,

**caractérisé en ce que**

des moyens de production de signaux d'erreur à partir des bits de canal sont prévus, auquel cas les signaux d'erreur indiquent une mesure des perturbations dans un bloc de bits reçu et/ou du mot de contrôle formé à partir de ce bloc de bits et sont prévus pour être amenés vers le circuit de masquage des erreurs (30, 34) et, dans le circuit de masquage des erreurs (30, 34) il est prévu en fonction des signaux d'erreur la production de signaux de classes d'erreur, une classe d'erreur étant déterminée par une valeur d'erreur et soit un signal d'erreur de mot de contrôle, soit un signal de perturbation, une modification des mots de code du bloc de bits reçu étant prévue d'une manière différente à l'aide des signaux de classes d'erreur.

2. Circuit selon la revendication 1, **caractérisé en ce que** le décodeur de canal (24) présente des première, deuxième et troisième sorties d'erreur (25, 26, 27) qui sont prévues pour la délivrance de signaux d'erreur et pour une alimentation vers un circuit de masquage des erreurs (30, 34) et il est prévu dans le circuit de masquage des erreurs (30, 34), en fonction des signaux d'erreur dans un circuit de classification, des signaux de classe d'erreur pour différentes erreurs des groupes de mots de code.

3. Circuit selon la revendication 1, **caractérisé en ce que** le décodeur de canal (24) est organisé pour délivrer à la sortie de canal (29) des premier, deuxième, troisième et quatrième groupes de mots de code, le premier groupe de mots de code indiquant des coefficients de filtrage, le deuxième groupe de mots de code des valeurs d'amplitude, le troisième groupe de mots de code des coefficients à long terme et le quatrième groupe de mots de code les différents signaux résiduels codés du signal de parole pour une reconstruction des signaux de parole à émettre.

4. Circuit selon la revendication 1, **caractérisé en ce que** le décodeur de canal (24) est organisé pour produire à une première sortie d'erreur (26) un signal d'erreur des mots de contrôle à chaque bloc de bits, le signal d'erreur des mots de contrôle étant dérivé d'un mot de contrôle contenu dans le bloc de bits reçu.

5. Circuit selon la revendication 4, **caractérisé en ce que**, pour la production d'une valeur d'erreur à une deuxième sortie d'erreur (27), il est prévu un circuit de codage (62) pour la production de signaux auxiliaires à codage de canal à partir des bits de canal décodés et un comparateur (64) pour la comparaison des signaux auxiliaires avec des bits de canal correspondants de la partie de réception (22) et pour la production de signaux d'erreur en cas de manque de concordance, un compteur (66) pour le comptage des signaux d'erreur et un circuit d'évaluation (68) couplé au compteur (66) pour la production de la valeur d'erreur à la deuxième sortie d'erreur (27).

6. Circuit selon la revendication 5, **caractérisé en ce que** le décodeur de canal (24) est organisé pour produire à une troisième sortie d'erreur (25) le signal de perturbation pour une indication d'une mesure probable des perturbations dans le bloc de bits reçu.

7. Circuit selon la revendication 2, **caractérisé en ce que** le circuit de masquage des erreurs (30, 34) présente

- un premier comparateur de valeur seuil (48) pour la comparaison de la valeur d'erreur d'une deuxième sortie d'erreur (27) avec plusieurs valeurs seuils d'erreur (47) et
- un deuxième comparateur de valeur seuil (46) pour comparer le signal perturbateur d'une troisième sortie d'erreur (25) avec une valeur seuil de perturbation,

et présente un circuit indicateur de perturbation (44) couplé au moins à une première sortie d'erreur (26) pour produire en fonction au moins du signal d'erreur du mot de contrôle un signal indicateur de perturbation (45) et que le circuit indicateur de perturbation (44) contient

- un circuit de liaison pour produire le signal indicateur de perturbation par liaison logique d'un signal de sortie du premier comparateur de valeur seuil (48), d'un signal de sortie du deuxième comparateur de valeur seuil (46) et du signal d'erreur du mot de contrôle de la première sortie d'erreur (26), et un
- circuit de classification (42) est prévu et couplé au premier comparateur de valeur seuil (48) pour produire, en fonction d'une valeur seuil d'erreur dépassée et du signal indicateur de perturbation d'un des plusieurs signaux de classes d'erreur différents et contient une commande de mot de code (50) commandée par les signaux de classe d'erreur afin de modifier, en fonction des signaux de classes d'erreur amenés, au moins quelques-uns des groupes de mots de code délivrés par le décodeur de canal (24), en particulier en remplaçant un groupe de mots de code dérivé des mots de code de la mémoire (52).

**8.** Circuit selon la revendication 1 dans une station fixe **caractérisé en ce que** le décodeur de canal (24) est organisé pour la production d'au moins les signaux d'erreur dans la station fixe (12, 14, 16) et le circuit de masquage des erreurs (34) est prévu pour la modification des mots de code du décodeur de canal (24) en fonction des signaux d'erreur de la station fixe (12, 14, 16) et le décodeur de parole (36) et un dispositif de commande (38) sont prévus dans une station centrale (10).

**9.** Système avec au moins une station fixe et au moins une station mobile pour la transmission de signaux de parole entre la station mobile (1 à 7) et la station fixe (12, 14, 16), chaque station contenant une partie d'émission pour la transformation des signaux de parole d'un segment temporel de durée préalablement déterminée en plusieurs groupes de mots de code composés de bits d'une signification différente et pour la transformation des bits en bits de canal d'un code de canal et la transmission des bits de canal comme bloc de bit ainsi qu'un circuit selon l'une des revendications 1 à 8.

**10.** Procédé de transmission de signaux de parole entre une première station fixe et au moins une deuxième station mobile, les signaux de parole d'un segment temporel préalablement déterminé étant transformés en plusieurs mots de code composés de bits d'une signification différente, les principaux bits des mots de code étant protégés par un mot de contrôle et les bits des mots de code étant codés dans les bits de canal d'un code de canal et transmis sous forme de bloc de bits à partir duquel les mots de code et les caractéristiques de qualité sont récupérés du côté réception par décodage de canal, des mesures de masquage des erreurs préalablement déterminées en cas de constatation d'une erreur à l'aide des caractéristiques de qualité étant déclenchées pour la production de mots de code modifiés et, à partir des mots de code ou, en présence d'une erreur, à partir des mots de code modifiés, des signaux de parole à délivrer sont formés, **caractérisé en ce que**, lors du décodage du canal, des informations sur les propriétés des erreurs des blocs de bits reçus sont produites comme caractéristiques de qualité, les informations étant formées à partir de blocs de bits et à partir du mot de contrôle formé à partir des blocs de bits et qu'en fonction de ces informations sont formées des classes d'erreur qui sont déterminées par une valeur d'erreur et soit un signal d'erreur de mots de contrôle ou un signal de perturbation et à l'aide desquelles les mots de code sont modifiés de manière différente.

**11.** Procédé selon la revendication 10, **caractérisé en ce que** des bits préalablement déterminés de groupes de mots de code sont dotés d'un mot de contrôle côté émission qui est récupéré côté réception

et qu'en cas de décodage du canal, une valeur d'erreur correspondant à une fréquence estimée des erreurs binaires est formée et est comparée à plusieurs valeurs seuils d'erreurs et qu'en fonction de la valeur seuil d'erreur dépassée et de la valeur d'un indicateur de perturbation qui dépend au moins d'une erreur reconnue à l'aide du mot de contrôle, un nombre préalablement déterminé de classes d'erreur est formé.

**12.** Procédé selon la revendication 10, **caractérisé en ce qu'**un indicateur de perturbation est formé comme une valeur binaire lorsqu'au moins une des conditions suivantes est remplie :

a) une erreur est reconnue à l'aide du mot de contrôle;
b) une valeur métrique formée lors du décodage du canal dépasse une valeur seuil métrique préalablement déterminée;
c) la valeur d'erreur dépasse une première valeur seuil d'erreur préalablement déterminée.

**13.** Procédé selon l'une des revendications 10 et 12, caractérisé en ce qu'une première classe d'erreur est formée lorsqu'en l'absence d'indicateur de perturbation, la valeur d'erreur se situe entre des première et troisième valeurs seuils d'erreur, des indications pour au moins les deux premiers coefficients de filtrage étant comparées avec des valeurs seuils de filtrage pour cette première classe d'erreur dans un premier groupe de mots de code et, en cas de dépassement de ces valeurs seuils de filtrage, par au moins une indication, un premier groupe de mots de code modifié est formé par le premier groupe de mots de code d'un bloc de bits enregistré précédent et, dans un deuxième groupe de mots de code, chaque valeur d'amplitude est comparée à une valeur moyenne d'amplitude dérivée des valeurs d'amplitude du bloc de bits précédent et, en cas d'écart par rapport à cette valeur moyenne d'amplitude d'une mesure préalablement déterminée dans le groupe de mots de code modifié, est remplacée par cette valeur moyenne d'amplitude et des troisième et quatrième groupes de mots de code modifiés sont identiques à un groupe de mots de code reçu correspondant,

qu'il est formé une deuxième classe d'erreurs lorsque, en présence de l'indicateur de perturbation, la valeur d'erreur ne dépasse pas une quatrième valeur seuil d'erreur ou, en l'absence d'indicateur de perturbation dans le bloc de bits précédent, l'indicateur de perturbation était présent et la valeur d'erreur dans le bloc de bits instantané dépasse une cinquième valeur seuil d'erreur et, pour cette deuxième classe d'erreurs, les premier et deuxième groupes des mots de code modifiés sont le groupe de mots de code enregistré correspondant du bloc de bits précédent et les troisième et quatrième groupes de mots de code modifiés sont identiques au groupe de mots de code reçu correspondant et

qu'il est formé une troisième classe d'erreurs lorsqu'en présence de l'indicateur de perturbation, la valeur d'erreur dépasse la quatrième valeur seuil d'erreur, les premier, deuxième et troisième groupes de mots de code modifiés pour cette troisième classe d'erreurs étant le groupe de mots de code enregistré correspondant du bloc de bits précédent et le quatrième groupe de mots de code modifié se compose d'une valeur aléatoire.

**14.** Procédé selon l'une des revendications 10 à 13,

**caractérisé en ce que**, pour un bloc de bits qui est reconnu comme un mot de commande sans information de parole, les mesures de masquage des erreurs sont réalisées conformément à la troisième classe d'erreurs.

**15.** Procédé selon l'une des revendications 10 à 14, **caractérisé en ce que**, au moins pour constater une erreur à l'aide du mot de contrôle dans deux blocs de bits successifs, le premier groupe de mots de code modifié est le premier groupe de mots de code enregistré du bloc de bits précédent et le groupe de mots de code modifié contient les valeurs d'amplitude réduites d'une valeur fixe du deuxième groupe de mots de code enregistré et le deuxième groupe de mots de code enregistré est remplacé par le deuxième mot de code modifié et, en cas de bloc de bits pour lequel la deuxième classe d'erreurs est formée, les troisième et quatrième groupes de mots de code modifiés sont le groupe de mots de code correspondant inchangé de ce bloc de bits et

qu'en cas de bloc de bits pour lequel la troisième classe d'erreurs est formée, le deuxième groupe de mots de code modifié pour toutes les valeurs d'amplitude est une valeur moyenne qui est formée à partir des valeurs d'amplitude du deuxième groupe de mots de code enregistré, hormis les plus petite et plus grande valeurs d'amplitude et le troisième groupe de mots de code modifié est le troisième groupe de mots de code enregistré du bloc de bit précédent et le quatrième groupe de mots de code modifié se compose d'une valeur aléatoire.

**16.** Procédé selon les revendications 10 à 15, **caractérisé en ce que** pendant des pauses de parole, il est produit comme signal de parole un bruit de fond qui est formé à partir des deux premiers groupes de mots de code d'un bloc de bits qui est caractérisé comme bloc de bits de bruit de fond et,

pour un bloc de bits de bruit de fond reconnu avec fiabilité pour lequel la valeur d'erreur est inférieure à une sixième valeur seuil d'erreur préalablement déterminée, le premier groupe de mots de code modifié est le premier groupe de mots de code reçu et, dans le deuxième groupe de mots de code reçu, les deux valeurs d'amplitude les plus extrêmes sont écartées et la valeur moyenne des valeurs d'amplitude résiduelles est utilisée pour toutes les valeurs d'amplitude dans le deuxième groupe de mots de code modifié et que, pour un bloc de bits de bruit de fond reconnu avec fiabilité dans lequel la valeur d'erreur est supérieure à la sixième valeur seuil d'erreur ou dans lequel l'indicateur de perturbation est présent ou pour un bloc de bits de bruit de fond reconnu non fiable comme premier et deuxième groupes de mots de code modifiés, les premier ou deuxième groupes de mots de code reçus dans un bloc de bits antérieur sont utilisés.

**17.** Procédé selon l'une des revendications 10 à 16, **caractérisé en ce que** la valeur d'erreur est formée par le fait que les bits de canal à décodage de canal font l'objet d'un nouveau codage de canal et les bits codés à nouveau sont comparés dans une position binaire exacte avec les bits reçus et les positions binaires sont comptées avec différentes valeurs binaires pour la production d'une valeur numérique et la valeur d'erreur est dérivée de la valeur numérique.

**18.** Procédé selon l'une des revendications 10 à 17, **caractérisé en ce que**, pour les blocs de bits transmis par la station mobile, les mesures de masquage des erreurs sont effectuées complètement dans la station fixe et seuls les mots de code caractérisés comme sans erreur sont délivrés.

FIG. 1

FIG. 4

EP 0 659 002 B1

FIG. 2

FIG. 3

22

FIG. 5

FIG. 6a

FIG. 6b

FIG. 6c

FIG. 6d

FIG. 6e

FIG. 6f